(19) Europäisches Patentamt
European Patent Office
Office européen des brevets

(11) **EP 4 260 357 B1**

(12) **EUROPEAN PATENT SPECIFICATION**

(45) Date of publication and mention
of the grant of the patent:
**01.01.2025 Bulletin 2025/01**

(21) Application number: **21820214.1**

(22) Date of filing: **25.11.2021**

(51) International Patent Classification (IPC):
***H01J 37/28*** *(2006.01)*    ***H01J 37/302*** *(2006.01)*
***H01J 37/317*** *(2006.01)*

(52) Cooperative Patent Classification (CPC):
**H01J 37/28; H01J 37/3026; H01J 37/3177;**
H01J 2237/2811; H01J 2237/31766

(86) International application number:
**PCT/EP2021/083024**

(87) International publication number:
**WO 2022/128392 (23.06.2022 Gazette 2022/25)**

(54) **CHARGED PARTICLE SYSTEM, METHOD OF PROCESSING A SAMPLE USING A MULTI-BEAM OF CHARGED PARTICLES**

SYSTEM FÜR GELADENE TEILCHEN, VERFAHREN ZUR BEARBEITUNG EINER PROBE UNTER VERWENDUNG EINES MEHRFACHSTRAHLS VON GELADENEN TEILCHEN

SYSTÈME DE PARTICULES CHARGÉES, PROCÉDÉ DE TRAITEMENT D'UN ÉCHANTILLON À L'AIDE D'UN FAISCEAU MULTIPLE DE PARTICULES CHARGÉES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **14.12.2020 EP 20213733**
**03.05.2021 EP 21171877**

(43) Date of publication of application:
**18.10.2023 Bulletin 2023/42**

(73) Proprietor: **ASML Netherlands B.V.**
**5500 AH Veldhoven (NL)**

(72) Inventor: **WIELAND, Marco Jan-Jaco**
**5500 AH Veldhoven (NL)**

(74) Representative: **ASML Netherlands B.V.**
**Corporate Intellectual Property**
**P.O. Box 324**
**5500 AH Veldhoven (NL)**

(56) References cited:
**WO-A1-2019/238553      US-A1- 2018 254 167**
**US-A1- 2020 203 121**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

CROSS-REFERENCE TO RELATED APPLICATIONS

This application claims priority of EP application 20213733.7 which was filed on 14 December 2020 and EP application 21171877.0 which was filed on 03 May 2021.

FIELD

The embodiments provided herein generally relate to charged-particle systems that use multiple sub-beams of charged particles.

BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over the sample surface, secondary electrons can be emitted across the surface of the sample. By collecting these emitted secondary electrons from the sample surface, a pattern inspection tool may obtain an image representing characteristics of the material structure of the surface of the sample.

There is a general need to improve the throughput and other characteristics of charged-particle tools. US 2018/254167 A1 discloses a method for imaging a surface of a substrate using a multi-beam of charged particles in a continuous scan mode. US 2020/203121 A1 discloses an image acquisition apparatus that uses a leap and scan method to irradiate a target with a multi-beam of charged particles.

WO 2019/238553 A1 discloses a system for scanning a sample using a multi-beam of charged particles in which sub-beams process interlaced sub-stripes.

SUMMARY

It is an object of the present disclosure to provide embodiments that support improvement of throughput or other characteristics of charged-particle tools.

According to an aspect of the invention, there is provided the method of claim 1.

According to an aspect of the invention, there is provided the charged-particle system of claim 15.

BRIEF DESCRIPTION OF FIGURES

The above and other aspects of the present disclosure will become more apparent from the description of exemplary embodiments, taken in conjunction with the accompanying drawings.

FIG. 1 is a schematic diagram illustrating an exemplary charged particle beam inspection apparatus.

FIG. 2 is a schematic diagram illustrating an exemplary multi-beam apparatus that is part of the exemplary charged particle beam inspection apparatus of FIG. 1.

FIG. 3 is a schematic diagram of an exemplary electron-optical system comprising a macro collimator and macro scan deflector.

FIG. 4 is a schematic diagram of an exemplary electron-optical system array.

FIG. 5 is a schematic diagram of an exemplary electron-optical system comprising a condenser lens array up-beam of an objective lens array assembly.

FIG. 6 is an enlarged diagram of a control lens and an objective lens.

FIG. 7 is a schematic side sectional view of a detector module integrated with a two-electrode objective lens array.

FIG. 8 is a bottom view of a detector module of the type depicted in FIG. 7.

FIG. 9 is a bottom view of an alternative detector module where beam apertures are in a hexagonal close packed array.

FIG. 10 depicts is an enlarged schematic cross-sectional view of a detector module for incorporation in the objective lens array of FIG. 7.

FIG. 11 schematically shows a leap and scan approach for scanning sub-beams over a sample.

FIG. 12 schematically shows a continuous scan approach for scanning sub-beams over a sample.

FIG. 13 depicts a framework of a method of processing a sample using a multi-beam of charged particles.

FIG. 14 depicts processing of a region on a sample corresponding to a sub-beam processed area.

FIG. 15 depicts positioning of sub-beams in a hexagonal grid.

**FIG. 16** depicts sub-beam processed areas corresponding to sub-beams arranged as shown in **FIG. 15.**

**FIG. 17** depicts alternating scanning of sub-beams within an elongate region.

**FIG. 18** depicts example short-stroke movement of a sample during processing of a sub-beam processed area.

**FIG. 19** depicts an example stage comprising a long-stroke stage and a short-stroke stage.

**FIG. 20** depicts example long-stroke movement of a sample between formation of different groups of sub-beam processed areas.

**FIG. 21** depicts example locations of three groups of sub-beam processed areas.

**FIG. 22** depicts example locations of three groups of sub-beam processed areas suitable for interleaving with the groups of sub-beam processed areas of **FIG. 21**.

**FIG. 23** depicts locations of all sub-beam processed areas corresponding to the groups of **FIG. 21** and of **FIG. 22.**

DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one "killer defect" can cause device failure. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection tools (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be more generally be considered to be references to charged particles, with the charged particles not necessarily being electrons.

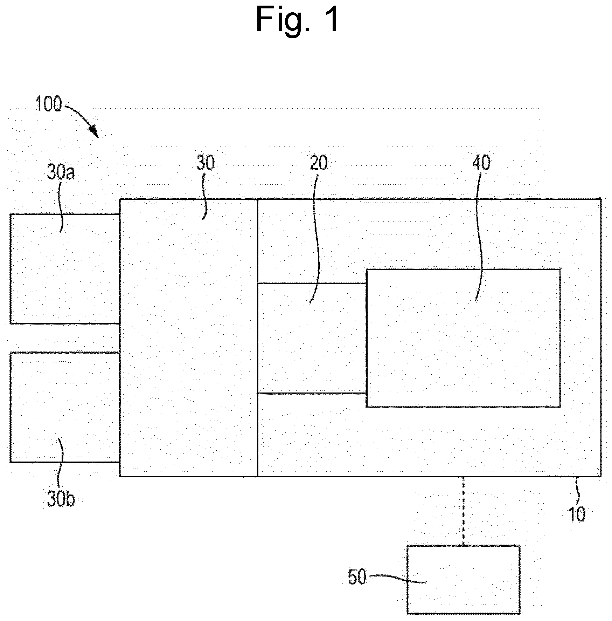

Reference is now made to **FIG. 1**, which is a schematic diagram illustrating an exemplary charged particle beam inspection apparatus 100. The charged particle beam inspection apparatus 100 of **FIG. 1** includes a main chamber 10, a load lock chamber 20, an electron beam tool 40, an equipment front end module (EFEM) 30 and a controller 50. Electron beam tool 40 is located within main chamber 10.

EFEM 30 includes a first loading port 30a and a second loading port 30b. EFEM 30 may include additional loading port(s). First loading port 30a and second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in EFEM 30 transport the samples to load lock chamber 20.

Load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from load lock chamber 20 to main chamber 10. Main chamber 10 is connected to a main chamber vacuum pump system (not shown). The main chamber vacuum pump system removes gas particles in main chamber 10 so that the pressure in around the sample reaches a second pressure lower than the first pressure. After reaching the second pressure, the sample is transported to the electron beam tool by which it may be inspected. An electron beam tool 40 may comprise a multi-beam electron-optical apparatus.

Controller 50 is electronically connected to electron beam tool 40. Controller 50 may be a processor (such as a computer) configured to control the charged particle beam inspection apparatus 100. Controller 50 may also include a processing circuitry configured to execute various signal and image processing functions. While controller 50 is shown in **FIG. 1** as being outside of the structure that includes main chamber 10, load lock chamber 20, and EFEM 30, it is appreciated that controller 50 may be part of the structure. The controller 50 may be located in one of the component elements of the charged particle beam inspection apparatus or it can be distributed over at least two of the component elements. While the present disclosure provides examples of main chamber 10 housing an electron beam inspection tool, it should be noted that aspects of the disclosure in their broadest sense are not limited to a chamber housing an electron beam inspection tool. Rather, it is appreciated that the foregoing principles may also be applied to other tools and other arrangements of apparatus, that operate under the second pressure.

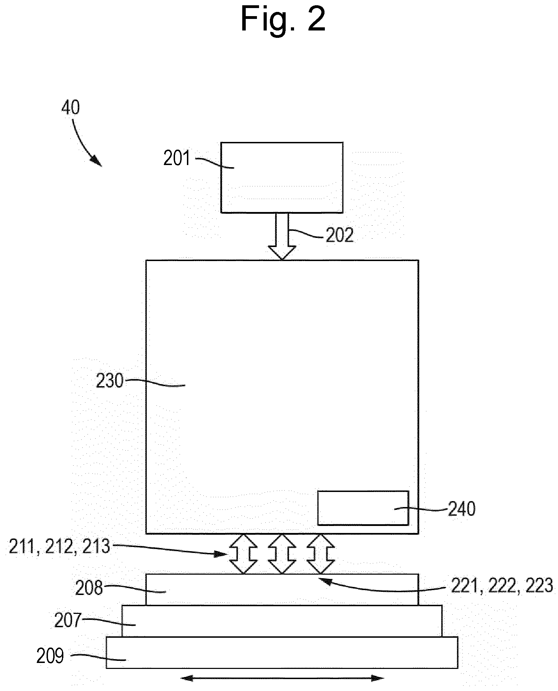

Reference is now made to **FIG. 2**, which is a schematic diagram illustrating an exemplary electron beam tool 40 including a multi-beam inspection tool that is part of the exemplary charged particle beam inspection apparatus 100 of **FIG. 1**. Multi-beam electron beam tool 40 (also referred to herein as apparatus 40) comprises an electron source 201, a projection apparatus 230, a motorized stage 209, and a sample holder 207. The electron source 201 and projection apparatus 230 may together be referred to as an illumination apparatus. The sample holder 207 is supported by motorized stage 209 so as to hold a sample 208 (e.g., a substrate or a mask) for inspection. Multi-beam electron beam tool 40 further comprises an electron detection device 240.

Electron source 201 may comprise a cathode (not shown) and an extractor or anode (not shown). During operation, electron source 201 is configured to emit electrons as primary electrons from the cathode. The primary electrons are extracted or accelerated by the extractor and/or the anode to form a primary electron beam 202.

Projection apparatus 230 is configured to convert primary electron beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets.

Controller 50 may be connected to various parts of charged particle beam inspection apparatus 100 of **FIG. 1**, such as electron source 201, electron detection device 240, projection apparatus 230, and motorized stage 209. Controller 50 may perform various image and signal processing functions. Controller 50 may also generate various control signals to govern operations of the charged particle beam inspection apparatus, including the charged particle multi-beam apparatus.

Projection apparatus 230 may be configured to focus sub-beams 211, 212, and 213 onto a sample 208 for inspection and may form three probe spots 221, 222, and 223 on the surface of sample 208. Projection apparatus 230 may be configured to deflect primary sub-beams 211, 212, and 213 to scan probe spots 221, 222, and 223 across individual scanning areas in a section of the surface of sample 208. In response to incidence of primary sub-beams 211, 212, and 213 on probe spots 221, 222, and 223 on sample 208, electrons are generated from the sample 208 which include secondary electrons and backscattered electrons. The secondary electrons typically have electron energy $\leq 50$ eV and backscattered electrons typically have electron energy between 50 eV and the landing energy of primary sub-beams 211, 212, and 213.

Electron detection device 240 is configured to detect secondary electrons and/or backscattered electrons and to generate corresponding signals which are sent to controller 50 or a signal processing system (not shown), e.g. to construct images of the corresponding scanned areas of sample 208. Electron detection device may be incorporated into the projection apparatus or may be separate therefrom, with a secondary optical column being provided to direct secondary electrons and/or backscattered electrons to the electron detection device.

The controller 50 may comprise image processing system that includes an image acquirer (not shown) and a storage device (not shown). For example, the controller may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to an electron detection device 240 of the apparatus 40 permitting signal communication, such as an electrical conductor, optical fiber cable, portable storage media, IR, Bluetooth, internet, wireless network, wireless radio, among others, or a combination thereof. The image acquirer may receive a signal from electron detection device 240, may process the data comprised in the signal and may construct an image therefrom. The image acquirer may thus acquire images of sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The image acquirer may acquire one or more images of a sample based on an imaging signal received from the electron detection device 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images of the sample structures under inspection. The reconstructed images can be used to reveal various features of the internal or external structures of sample 208. The reconstructed images can thereby be used to reveal any defects that may exist in the sample.

The controller 50 may control motorized stage 209 to move sample 208 during inspection of sample 208. The controller 50 may enable motorized stage 209 to move sample 208 in a direction, preferably continuously, for example at a constant speed, at least during sample inspection. The controller 50 may control movement of the motorized stage 209 so that it changes the speed of the movement of the sample 208 dependent on various parameters. For example, the controller may control the stage speed (including its direction) depending on the characteristics of the inspection steps of scanning process.

Embodiments of the present disclosure provide an objective lens array assembly. The objective lens array assembly may be configured to focus a multi-beam of sub-beams on a sample. The objective lens array assembly may be incorporated into an electron-optical system of a charged-particle tool such as a charged particle assessment tool. Such electron-optical systems are examples of columns that direct a multi-beam of sub-beams of charged particles onto a sample surface for the specific case where the charged particles are electrons.

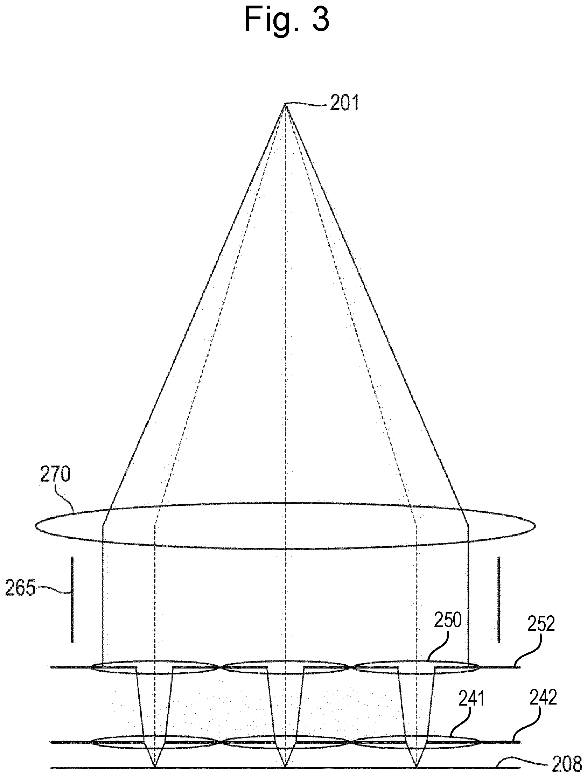

FIG. 3 is a schematic diagram of an exemplary electron-optical system having the objective lens array assembly. The objective lens array assembly comprises planar elements defining a plurality of apertures aligned along sub-beam paths of the multi-beam. The objective lens array assembly comprises an objective lens array 241. The planar elements of the objective lens array assembly comprise the objective lens array 241. The objective lens array 241 may comprise a plurality of the planar elements. The planar elements of the objective lens array 241 may be configured to act as electrodes. The planar elements may, for example, be metallic and/or configured to be connected to respective potential sources. The planar elements of the objective lens array 241 may be referred to as electrodes or plate electrode arrays. A plurality of apertures that are aligned along each sub-beam path may be defined in different respective planar elements (electrodes) of the objective lens array 241. The positions of apertures defined in one of the planar elements of the objective lens array 241 thus correspond to the positions of corresponding apertures in one or more other planar elements of the objective lens array 241. Each group of apertures aligned along a sub-beam path define one of the objective lenses and operates in use on the same sub-beam in the multi-beam. Each objective lens projects a respective sub-beam of the multi-beam onto a sample 208. The objective lens array 241 comprises a plurality of the objective lenses.

For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. As described above, lens arrays may instead comprise multiple planar elements defining apertures.

In some embodiments, the planar elements of the objective lens array assembly further comprise a control lens array 250. The control lens array 250 comprises a plurality of control lenses. Each control lens comprises at least two planar elements configured to act as electrodes (e.g. two or three planar elements configured to act as electrodes). The planar elements of the control lens array 250 may be connected to respective potential sources. The planar elements of the control lens array 250 may be referred to as electrodes. The control lens array 250 may comprise two or more (e.g. three) plate electrode arrays connected to respective potential sources. Each plate electrode array is mechanically connected to, and electrically separated from, an adjacent plate electrode array by an isolating element, such as a spacer which may comprise ceramic or glass. The control lens array 250 is associated with the objective lens array 241 (e.g. the two arrays are positioned close to each other and/or mechanically connected to each other and/or controlled together as a unit). The control lens array 250 is positioned up-beam of the objective lens array 241. The control lenses pre-focus the sub-beams (e.g. apply a focusing action to the sub-beams prior to the sub-beams reaching the objective lens array 241). The pre-focusing may reduce divergence of the sub-beams or increase a rate of convergence of the sub-beams. In an embodiment, an electron-optical system comprising the objective lens array assembly is configured to control the objective lens array assembly (e.g. by controlling potentials applied to electrodes of the control lens array 250) so that a focal length of the control lenses is larger than a separation between the control lens array 250 and the objective lens array 241. The control lens array 250 and objective lens array 241 may thus be positioned relatively close together, with a focusing action from the control lens array 250 that is too weak to form an intermediate focus between the control lens array 250 and objective lens array 241. The control lens array and the objective lens array operate together to form a combined focal length to the same surface. Combined operation without an intermediate focus may reduce the risk of aberrations. In other embodiments, the objective lens array assembly may be configured to form an intermediate focus between the control lens array 250 and the objective lens array 241.

An electric power source may be provided to apply respective potentials to electrodes of the control lenses of the control lens array 250 and the objective lenses of the objective lens array 241.

The provision of a control lens array 250 in addition to an objective lens array 241 provides additional degrees of freedom for controlling properties of the sub-beams. The additional freedom is provided even when the control lens array 250 and objective lens array 241 are provided relatively close together, for example such that no intermediate focus is formed between the control lens array 250 and the objective lens array 241. The control lens array 250 may be used to optimize a beam opening angle with respect to the demagnification of the beam and/or to control the beam energy delivered to the objective lens array 241. The control lens array 250 may comprise 2 or 3 or more electrodes. If there are two electrodes then the demagnification and landing energy are controlled together. If there are three or more electrodes the demagnification and landing energy can be controlled independently. The control lenses may thus be configured to adjust the demagnification and/or beam opening angle and/or the landing energy on the sample of respective sub-beams (e.g. using the electric power source to apply suitable respective potentials to the electrodes of the control lenses and the objective lenses). This optimization can be achieved without having an excessively negative impact on the number of objective lenses and without excessively deteriorating aberrations of the objective lenses (e.g. without decreasing the strength of the objective lenses). Use of the control lens array enables the objective lens array to operate at its optimal electric field strength. Note that it is intended that the reference to demagnification and opening angle is intended to refer to variation of the same parameter. In an ideal arrangement the product of a range of demagnification and the corresponding opening angles is constant. However, the opening angle may be influenced by the use of an aperture.

In an embodiment, the landing energy can be controlled to a desired value in a predetermined range, e.g. from 1000 eV to 5000 eV. The resolution of the tool can be kept substantially constant with change in landing energy down to a minimum value LE_min. Resolution deteriorates below LE_min because it is necessary to reduce the lens strength of, and electric fields within, the objective lenses in order to maintain a minimum spacing between objective lenses and/or detector and the sample.

Desirably, the landing energy is primarily varied by controlling the energy of the electrons exiting the control lenses. The potential differences within the objective lenses are preferably kept constant during this variation so that the electric field within the objective lenses remains as high as possible. The potentials applied to the control lenses in addition may be used to optimize the beam opening angle and demagnification. The control lenses can function to change the demagnification in view of changes in landing energy. Desirably, each control lens comprises three electrodes so as to provide two independent control variables. For example, one of the electrodes can be used to control magnification while a different electrode can be used to independently control landing energy. Alternatively each control lens may have only two electrodes. When there are only two electrodes, one of the electrodes may need to control both magnification and landing energy.

In the embodiment of **FIG. 3**, the electron-optical system comprises a source 201. The source 201 provides a beam of charged particles (e.g. electrons). The multi-beam focused on the sample 208 is derived from the beam provided by the source 201. Sub-beams may be derived from the beam, for example, using a beam limiter defining an array of beam-limiting apertures. The source 201 is desirably a high brightness thermal field emitter with a good compromise between brightness and total emission current. In the example shown, a collimator is provided up-beam of the objective lens array assembly. The collimator may comprise a macro collimator 270. The macro collimator 270 acts on the beam from the source 201 before the beam has been split into a multi-beam. The macro collimator 270 bends respective portions of the beam by an amount effective to ensure that a beam axis of each of the sub-beams derived from the beam is incident on the sample 208 substantially normally (i.e. at substantially 90° to the nominal surface of the sample 208). The macro collimator 270 applies a macroscopic collimation to the beam. The macro collimator 270 may thus act on all of the beam rather than comprising an array of collimator elements that are each configured to act on a different individual portion of the beam. The macro collimator 270 may comprise a magnetic lens or magnetic lens arrangement comprising a plurality of magnetic lens sub-units (e.g. a plurality of electromagnets forming a multi-pole arrangement). Alternatively or additionally, the macro-collimator may be at least partially implemented electrostatically. The macro-collimator may comprise an electrostatic lens or electrostatic lens arrangement comprising a plurality of electrostatic lens sub-units. The macro collimator 270 may use a combination of magnetic and electrostatic lenses.

In the embodiment of **FIG. 3** a macro scan deflector 265 is provided to cause sub-beams to be scanned over the sample 208. The macro scan deflector 265 deflects respective portions of the beam to cause the sub-beams to be scanned over the sample 208. In an embodiment, the macro scan deflector 256 comprises a macroscopic multi-pole deflector, for example with eight poles or more. The deflection is such as to cause sub-beams derived from the beam to be scanned across the sample 208 in one direction (e.g. parallel to a single axis, such as an X axis) or in two directions (e.g. relative to two non-parallel axes, such as X and Y axes). The macro scan deflector 265 acts macroscopically on all of the beam rather than comprising an array of elements that are each configured to act on a different individual portion of the beam. In the embodiment shown, the macro scan deflector 265 is provided between the macro collimator 270 and the control lens array 250.

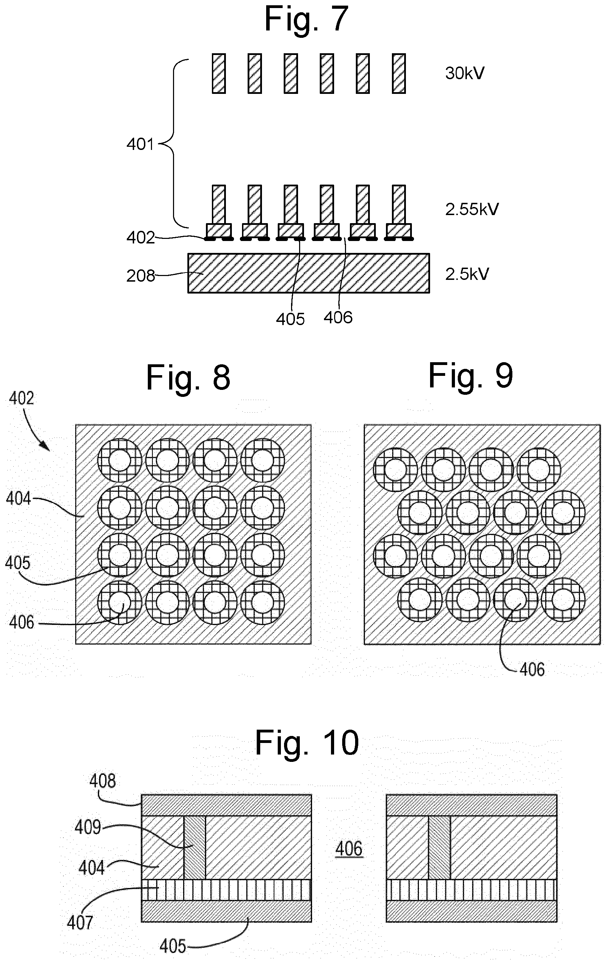

Any of the objective lens array assemblies described herein may further comprise a detector (e.g. comprising a detector module 402). The detector detects charged particles emitted from the sample 208. The detected charged particles may include any of the charged particles detected by an SEM, including secondary and/or backscattered electrons emitted from the sample 208. At least portion of the detector may be adjacent to and/or integrated with the objective lens array241. The detector may provide a sample facing surface of the objective lens array assembly. An exemplary construction of a detector is described below with reference to **FIGs. 7-10**. The detector and objective lens may be part of the same structure. The detector may be connected to the lens by an isolating element or directly to an electrode of the objective lens.

In a variation on the embodiment of **FIG. 3**, the objective lens array assembly may comprise a scan-deflector array. The scan-deflector array comprises a plurality of scan deflectors. The scan-deflector array 260 may be formed using MEMS manufacturing techniques. Each scan deflector scans a respective sub-beam over the sample 208. The scan-deflector array 260 may thus comprise a scan deflector for each sub-beam. Each scan deflector may deflect the sub-beam in one direction (e.g. parallel to a single axis, such as an X axis) or in two directions (e.g. relative to two non-parallel axes, such as X and Y axes). The deflection is such as to cause the sub-beam to be scanned across the sample 208 in the one or two directions (i.e. one dimensionally or two dimensionally). In an embodiment, the scanning deflectors described in EP2425444 may be used to implement the scan-deflector array. The scan-deflector array is positioned between the objective lens array 241 and the control lens array 250. The scan-deflector array may be provided instead of the macro scan deflector 265. A scan-deflector array (e.g. formed using MEMS manufacturing techniques as mentioned above) may be more spatially compact than a macro scan deflector 265.

In other embodiments both the macro scan deflector 265 and the scan-deflector array are provided. In such an arrangement, the scanning of the sub-beams over the sample surface may be achieved by controlling the macro scan deflector 265 and the scan-deflector array together, preferably in synchronization.

The provision of a scan-deflector array instead of a macro scan deflector 265 can reduce aberrations from the control lenses. This may arise because the scanning action of the macro scan deflector 265 causes a corresponding movement of beams over a beam shaping limiter (which may also be referred to as a lower beam limiter) defining an array of beam-limiting apertures down-beam of at least one electrode of the control lenses, which increases a contribution to aberration from the control lenses. When a scan-deflector array is used instead the beams are moved by a much smaller amount over the beam shaping limiter. This is because the distance from the scan-deflector array to the beam shaping limiter is much shorter. Because of this it is preferable to position the scan-deflector array as close as possible to the objective lens array 241 (e.g. such that the scan-deflector array is directly adjacent to the objective lens array 241 and/or closer to the objective lens array 241 than to the control lens array 250). The smaller movement over the beam shaping limiter results in a smaller part of each control lens being used. The control lenses thus have a smaller aberration contribution. To minimize, or at least reduce, the aberrations contributed by the control lenses the beam shaping limiter is used to shape beams down beam from at least one electrode of the control lenses. This differs architecturally from conventional systems in which a beam shaping limiter is provided only as an aperture array that is part of or associated with a first manipulator array in the beam path and commonly generates the multi-beams from a single beam from a source. Despite the function of the beam shaping limiter, the sub-beams may be derived from the beam, using a beam limiter defining an array of beam-limiting apertures, for example as described above.

In some embodiments, as exemplified in **FIG. 3**, the control lens array 250 is the first deflecting or lensing electron-optical array element in the beam path down-beam of the source 201.

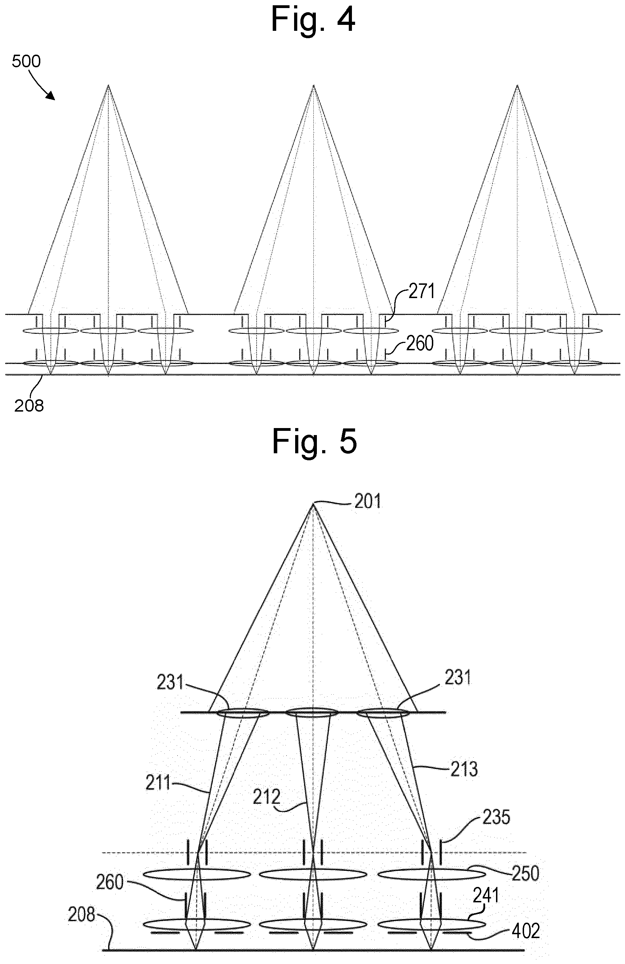

In a variation on the embodiment of **FIG. 3** or on the variation discussed above where a scan-deflector array is provided, a collimator element array may be provided instead of the macro collimator 270. Each collimator element collimates a respective sub-beam. The collimator element array (e.g. formed using MEMS manufacturing techniques) may be more spatially compact than a macro collimator 270. Providing the collimator element array and the scan-deflector array together may therefore provide space saving. This space saving is desirable where a plurality of the electron-optical systems comprising the objective lens array assembly are provided in an electron-optical system array 500, as discussed below with reference to **FIG. 4**. In such an embodiment there may be no macro condenser lens or a condenser lens array. In this scenario, the control lens provides the possibility to optimize the beam opening angle and magnification for changes in landing energy. Note that the beam shaping limiter is downbeam of the control lens array. The apertures in the beam shaping limiter adjust the beam current along the beam path so that control of the magnification by the control lens operates differently on the opening angle. That is the apertures in the beam shaping limiter break the direct correspondence between variations in the magnification and opening angle.

In some embodiments, the collimator element array is the first deflecting or focusing electron-optical array element in the beam path down-beam of the source 201.

Avoiding any deflecting or lensing electron-optical array elements (e.g. lens arrays or deflector arrays) up-beam of the control lens array 250 or up-beam of the collimator element array reduces requirements for electron-optics up-beam of the objective lenses, and for correctors to correct for imperfections in such electron-optics, i.e. aberrations generated in the sub-beams by such optics. For example, some alternative arrangements seek to maximize source current utilization by providing a condenser lens array in addition to an objective lens array (as discussed below with reference to **FIG. 5**). The provision of a condenser lens array and an objective lens array in this manner results in stringent requirements on position of the virtual source position uniformity over the source opening angle, or requires corrective optics per sub-beam in order to make sure each sub-beam passes through the center of its corresponding objective lens down-beam. Architectures such as those of **FIG. 3** and the variations thereof discussed above allow the beam path from the first deflecting or lensing electron-optical array element to a down-beam beam shaping limiter to be reduced to less than about 10mm, preferably to less than about 5mm, preferably to less than about 2mm. Reducing the beam path reduces or removes the stringent requirements on virtual source position over the source opening angle. The electron-optical column of such architectures as depicted and described with reference to **FIGs. 3**, **5** and **6** may comprise components such as an upper beam limiter 252, a collimator element array 271, a control lens array 250, a scan deflector array 260, an objective lens array 241, a beam shaping limiter 242 and a detector array 240; one or more of these elements that are present may be connected to one more adjacent elements with an isolating element such as a ceramic or glass spacer.

In an embodiment, as exemplified in **FIG. 4**, an electron-optical system array 500 is provided. The array 500 may comprise a plurality of any of the electron-optical systems described herein. Each of the electron-optical systems focuses respective multi-beams simultaneously onto different regions of the same sample. Each region, in this context, may thus correspond to a portion or part of the surface of a sample. Each electron-optical system may form sub-beams from a beam of charged particles from a different respective source 201. Each respective source 201 may be one source in a plurality of sources 201. At least a subset of the plurality of sources 201 may be provided as a source array. The source array may comprise a plurality of sources 201 provided on a common substrate. The focusing of plural multi-beams simultaneously onto different regions of the same sample allows an increased area of the sample 208 to be processed (e.g. assessed) simultaneously. The electron-optical systems in the array 500 may be arranged adjacent to each other so as to project the respective multi-beams onto adjacent regions of the sample 208. Any number of electron-optical systems may be used in the array 500. Preferably, the number of electron-optical systems is in the range of from 9 to 200. In an embodiment, the electron-optical systems are arranged in a rectangular array or in a hexagonal array. In other embodiments, the electron-optical systems are provided in an irregular array or in a regular array having a geometry other than rectangular or hexagonal. Each electron-optical system in the array 500 may be configured in any of the ways described herein when referring to a single electron-optical system, for example as described above. Details of such an arrangement is described in EPA 20184161.6 filed 6 July 2020 which, with respect to how the objective lens is incorporated and adapted for use in the multi-column arrangement is hereby referred to. In the example of **FIG. 4**, each of the electron-optical systems comprises both a scan-deflector array 260 and a collimator element array 271. As mentioned above, the scan-deflector array 260 and collimator element array 271 are particularly well suited to incorporation into an electron-optical system array 500 because of their spatial compactness, which facilitates positioning of the electron-optical systems close to each other. The arrangement with both a scan-deflector array 260 and a collimator element array 271 may be preferred over the arrangement shown in **FIG. 3** where preferred implementations may use a magnetic lens as collimator 270. Magnetic lenses may be challenging to incorporate into an electron-optical system intended for use in an array (a multi-column arrangement).

**FIG. 5** depicts a variation on the embodiment of **FIG. 3** (and variations thereon discussed above) in which a condenser lens array 231 is provided between the source 201 and the objective lens array assembly. The condenser lens array is thus upbeam of the objective lens array assembly. Such an arrangement is described in EPA 20158804.3 at least with respect to the architecture shown in Fig 4. The arrangement may also be incorporated in a multi-column array, for example EPA 20206987.8 filed 11 November 2020, such as that discussed above with reference to **FIG. 4**. The condenser lens array 231 comprises a plurality of condenser lenses. There may be many tens, many hundreds or many thousands of condenser lenses. The condenser lenses may comprise multi-electrode lenses and have a construction based on EP1602121A1, which document is referred to in particular to the disclosure of a lens array to split an e-beam into a plurality of sub-beams, with the array providing a lens for each sub-beam. The condenser lens array 231 may be configured to generate the multi-beam. The condenser lens array may take the form of at least two planar elements (which may be referred to as plates), acting as electrodes, with an aperture in each plate aligned with each other and corresponding to the location of a sub-beam. At least two of the planar elements are maintained during operation at different potentials to achieve the desired lensing effect. The planar elements of the condenser lens array 231 may be referred to as plate arrays.

In an arrangement the condenser lens array is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

The condenser lens array 231 may have two or more plate electrodes each with an array of apertures that are aligned. Each plate electrode array is mechanically connected to, and electrically isolated from, an adjacent plate electrode array by an isolating element, such as a spacer which may comprise ceramic or glass. The condenser lens array may be connected and/or spaced apart from an adjacent electron-optical element, preferably an electrostatic electron-optical element, by an isolating element such as a spacer as described elsewhere herein.

The condenser lenses are separated from a module containing the objective lenses (such as an objective lens array assembly as discussed elsewhere herein). In a case where the potential applied on a bottom surface of the condenser lenses is different than the potential applied on the top surface of the module containing the objective lenses an isolating spacer is used to space apart the condenser lenses and the module containing the objective lenses. In a case where the potential is equal then a conductive element can be used to space apart the condenser lenses and the module containing the objective lenses.

Each condenser lens in the array directs electrons into a respective sub-beam 211, 212, 213 which is focused at a respective intermediate focus. Each condenser lens forms a respective intermediate focus between the condenser lens array 231 and a respective objective lens in the objective lens array assembly. The condenser lens array 231 is preferably configured such that the sub-beam paths diverge with respect to each other between the condenser lens array 231 and a plane of intermediate focuses. In the embodiment shown, deflectors 235 are provided at the intermediate focuses (i.e. in the plane of intermediate focuses). Deflectors 235 are configured to bend a respective beamlet 211, 212, 213 by an amount effective to ensure that the principal ray (which may also be referred to as the beam axis) is incident on the sample 208 substantially normally (i.e. at substantially 90° to the nominal surface of the sample). Deflectors 235 may also be referred to as collimators. The deflectors 235 in effect collimate the paths of the beamlets so that before the deflectors, the beamlets paths with respect to each other are diverging. Down beam of the deflectors the beamlet paths are substantially parallel with respect to each other, i.e. substantially collimated. Suitable collimators are deflectors disclosed in EP Application 20156253.5 filed on 7 February 2020 which is hereby referred to with respect to the application of the deflectors to a multi-beam array.

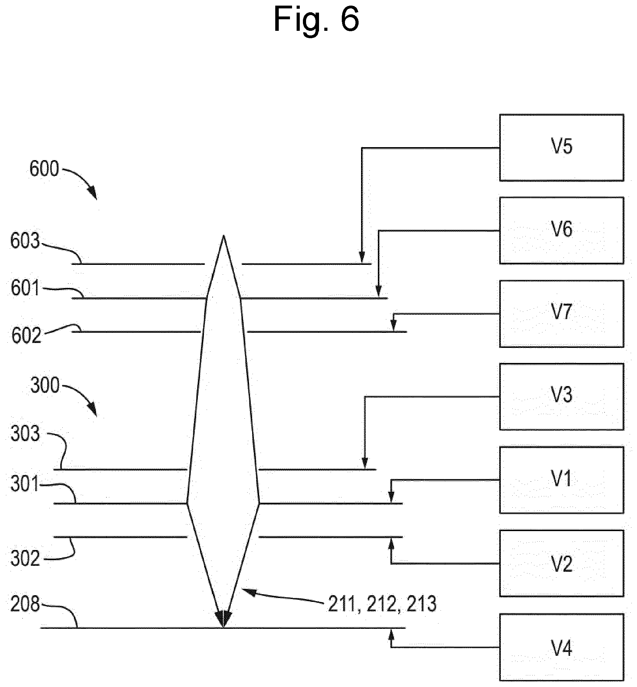

**FIG. 6** is an enlarged schematic view of one objective lens 300 of the objective lens array 241 and one control lens 600 of the control lens array 250. Objective lens 300 can be configured to de-magnify the electron beam by a factor greater than 10, desirably in the range of 50 to 100 or more. The objective lens 300 comprises a middle or first electrode 301, a lower or second electrode 302 and an upper or third electrode 303. Voltage sources V1, V2, V3 are configured to apply potentials to the first second and third electrodes respectively. A further voltage source V4 is connected to the sample to apply a fourth potential, which may be ground. Potentials can be defined relative to the sample 208. The first, second and third electrodes are each provided with an aperture through which the respective sub-beam propagates. The second potential can be similar to the potential of the sample, e.g. in the range of from 50 V to 200 V more positive than the sample. Alternatively the second potential can be in the range of from about +500 V to about +1,500 V more positive than the sample. A higher potential is useful if a detector is higher in the optical column than the lowest electrode. The first and/or second potentials can be varied per aperture or group of apertures to effect focus corrections.

Desirably, in an embodiment the third electrode is omitted. An objective lens having only two electrodes can have lower aberration than an objective lens having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beam.

As mentioned above, it is desirable to use the control lens to determine the landing energy. However, it is possible to use in addition the objective lens 300 to control the landing energy. In such a case, the potential difference over the objective lens is changed when a different landing energy is selected. One example of a situation where it is desirable to partly change the landing energy by changing the potential difference over the objective lens is to prevent the focus of the sub-beams getting too close to the objective lens. In such a situation there is a risk of the objective lens electrode having to be too thin to be manufacturable. The same may be said about a detector at this location. This situation can for example occur in case the landing energy is lowered. This is because the focal length of the objective lens roughly scales with the landing energy used. By lowering the potential difference over the objective lens, and thereby lowering the electric field inside the objective lens, the focal length of the objective lens is made larger again, resulting in a focus position further below the objective lens. Note that use of just an objective lens would limit control of magnification. Such an arrangement could not control demagnification and/or opening angle. Further, using the objective lens to control the landing energy could mean that the objective lens would be operating away from its optimal field strength. That is unless mechanical parameters of the objective lens (such as the spacing between its electrodes) could be adjusted, for example by exchanging the objective lens.

In the arrangement depicted, the control lens 600 comprises three electrodes 601 - 603 connected to potential sources V5 to V7. Electrodes 601 - 603 may be spaced a few millimeters (e.g. 3mm) apart. The spacing between the control lens and the objective lens (i.e. the gap between lower electrode 602 and the upper electrode of the objective lens) can be selected from a wide range, e.g. from 2mm to 200 mm or more. A small separation makes alignment easier whereas a larger separation allows a weaker lens to be used, reducing aberrations. Desirably, the potential V5 of the uppermost electrode 603 of the control lens 600 is maintained the same as the potential of the next electron-optic element up-beam of the control lens (e.g. deflectors 235). The potential V7 applied to the lower electrode 602 can be varied to determine the beam energy. The potential V6 applied to the middle electrode 601 can be varied to determine the lens strength of the control lens 600 and hence control the opening angle and demagnification of the beam. Desirably, the lower electrode 602 of the control lens and the uppermost electrode of the objective lens have substantially the same potential. The sample and the lowest electrode of the objective lens typically have a very different potential than the lowest electrode of the control lens. The electrons may for example be decelerated from 30kV to 2.5kV in the objective lens. In one design the upper electrode of the objective lens V3 is omitted. In this case desirably the lower electrode 602 of the control lens and electrode 301 of the objective lens have substantially the same potential. It should be noted that even if the landing energy does not need to be changed, or is changed by other means, the control lens can be used to control the beam opening angle. The position of the focus of a sub-beam is determined by the combination of the actions of the respective control lens and the respective objective lens.

When the control lens, rather than the condenser lens of for example the embodiment of **FIG. 5**, is used for opening angle/magnification correction of the electron beam, the collimator remains at the intermediate focus so there is no need for astigmatism correction of the collimator. (It should be noted that in such an arrangement adjustment of magnification results in similar adjustment of the opening angle because the beam current remains consistent along the beam path). In addition, the landing energy can be varied over a wide range of energies whilst maintaining an optimum field strength in the objective lens. This minimizes aberrations of the objective lens. The strength of the condenser lens (if used) is also maintained constant, avoiding any introduction of additional aberrations due to the collimator not being at the intermediate focal plane or to changes in the path of the electron through the condenser lens. Further, when the control lens of an embodiment featuring a beam-shaping limiter such as shown in **FIG. 3** (which does not have a condenser lens), is used the opening angle/magnification may additionally be controlled as well as the landing energy.

In some embodiments, the charged particle tool further comprises one or more aberration correctors that reduce one or more aberrations in the sub-beams. In an embodiment, each of at least a subset of the aberration correctors is positioned in, or directly adjacent to, a respective one of the intermediate foci (e.g. in or adjacent to the intermediate image plane) in embodiments of the type depicted in **FIG. 5**. The sub-beams have a smallest cross-sectional area in or near a focal plane such as the intermediate plane (a plane of intermediate focuses). This provides more space for aberration correctors than is available elsewhere, i.e. upbeam or downbeam of the intermediate plane (or than would be available in alternative arrangements that do not have an intermediate plane).

In an embodiment, aberration correctors positioned in, or directly adjacent to, the intermediate foci (or intermediate plane) comprise deflectors to correct for the source 201 appearing to be at different positions for different beams. Correctors can be used to correct macroscopic aberrations resulting from the source that prevent a good alignment between each sub-beam and a corresponding objective lens.

The aberration correctors may correct aberrations that prevent a proper column alignment. Such aberrations may also lead to a misalignment between the sub-beams and the correctors. For this reason, it may be desirable to additionally or alternatively position aberration correctors at or near the condenser lenses of the condenser lens array 231 (e.g. with each such aberration correctors being integrated with, or directly adjacent to, one or more of the condenser lenses). This is desirable because at or near the condenser lenses aberrations will not yet have led to a shift of corresponding sub-beams because the condenser lenses are vertically close or coincident with the beam apertures. A challenge with positioning correctors at or near the condenser lenses, however, is that the sub-beams each have relatively large sectional areas and relatively small pitch at this location, relative to locations further downstream (or down-beam). The condenser lenses and correctors may be part of the same structure. For example they may be connected to each other, for example with an electrically isolating element.

In some embodiments, each of at least a subset of the aberration correctors is integrated with, or directly adjacent to, one or more of the objective lenses or control lenses in the objective lens array assembly. In an embodiment, these aberration correctors reduce one or more of the following: field curvature; focus error; and astigmatism. The objective lenses and/or control lenses and correctors may be part of the same structure. For example they may be connected to each other, for example with an electrically isolating element.

The aberration correctors may be CMOS based individual programmable deflectors as disclosed in EP2702595A1 or an array of multipole deflectors as disclosed EP2715768A2.

In some embodiments, the detector of the objective lens array assembly comprises a detector module down-beam of at least one electrode of the objective lens array 241. In an embodiment, at least a portion of the detector (e.g. the detector module) is adjacent to and/or integrated with the objective lens array 241. For example, the detector module may be implemented by integrating a CMOS chip detector into a bottom electrode of the objective lens array 241. Integration of a detector module into the objective lens array assembly replaces a secondary column. The CMOS chip is preferably orientated to face the sample (because of the small distance (e.g. 100μm) between sample and bottom of the electron-optical system) and thereby provide a sample facing surface of the assembly. In an embodiment, electrodes to capture the secondary electron signals are formed in the top metal layer of the CMOS device. The electrodes can be formed in other layers. Power and control signals of the CMOS may be connected to the CMOS by through-silicon vias. For robustness, preferably the bottom electrode consists of two elements: the CMOS chip and a passive Si plate with holes. The plate shields the CMOS from high E-fields.

In order to maximize the detection efficiency it is desirable to make the electrode surface as large as possible, so that substantially all the area of the objective lens array 241 (excepting the apertures) is occupied by electrodes and each electrode has a diameter substantially equal to the array pitch. In an embodiment the outer shape of the electrode is a circle, but this can be made a square to maximize the detection area. Also the diameter of the through-substrate hole can be minimized. Typical size of the electron beam is in the order of 5 to 15 micron.

In an embodiment, a single electrode surrounds each aperture. In another embodiment, a plurality of electrode elements are provided around each aperture. The electrons captured by the electrode elements surrounding one aperture may be combined into a single signal or used to generate independent signals. The electrode elements may be divided radially (i.e. to form a plurality of concentric annuluses), angularly (i.e. to form a plurality of sector-like pieces), both radially and angularly or in any other convenient manner.

However a larger electrode surface leads to a larger parasitic capacitance, so a lower bandwidth. For this reason it may be desirable to limit the outer diameter of the electrode. Especially in case a larger electrode gives only a slightly larger detection efficiency, but a significantly larger capacitance. A circular (annular) electrode may provide a good compromise between collection efficiency and parasitic capacitance.

A larger outer diameter of the electrode may also lead to a larger crosstalk (sensitivity to the signal of a neighboring hole). This can also be a reason to make the electrode outer diameter smaller. Especially in case a larger electrode gives only a slightly larger detection efficiency, but a significantly larger crosstalk.

The back-scattered and/or secondary electron current collected by the electrode may be amplified by a Trans Impedance Amplifier.

An exemplary embodiment of a detector integrated into an objective lens array is shown in **FIG. 7**. **FIG. 7** shows a portion 401 of the objective lens array in schematic cross-section. In this embodiment, the detector comprises a detector module 402 comprising a plurality of detector elements 405 (e.g. sensor elements such as capture electrodes). In this embodiment, the detector module 402 is provided on an output side of the objective lens array. The output side is the side facing the sample 208. **FIG. 8** is a bottom view of detector module 402 which comprises a substrate 404 on which are provided a plurality of capture electrodes 405 each surrounding a beam aperture 406. The beam apertures 406 may be formed by etching through substrate 404. In the arrangement shown in **FIG. 8**, the beam apertures 406 are shown in a rectangular array. The beam apertures 406 can also be differently arranged, e.g. in a hexagonal close packed array as depicted in **FIG. 9.**

**FIG. 10** depicts at a larger scale a part of the detector module 402 in cross section. Capture electrodes 405 form the bottommost, i.e. most close to the sample, surface of the detector module 402. Between the capture electrodes 405 and the main body of the silicon substrate 404 a logic layer 407 is provided. Logic layer 407 may include amplifiers, e.g. Trans Impedance Amplifiers, analogue to digital converters, and readout logic. In an embodiment, there is one amplifier and one analogue to digital converter per capture electrode 405. Logic layer 407 and capture electrodes 405 can be manufactured using a CMOS process with the capture electrodes 405 forming the final metallisation layer.

A wiring layer 408 is provided on the backside of, or within, substrate 404 and connected to the logic layer 407 by through-silicon vias 409. The number of through-silicon vias 409 need not be the same as the number of beam apertures 406. In particular if the electrode signals are digitized in the logic layer 407 only a small number of through-silicon vias may be required to provide a data bus. Wiring layer 408 can include control lines, data lines and power lines. It will be noted that in spite of the beam apertures 406 there is ample space for all necessary connections. The detector module 402 can also be fabricated using bipolar or other manufacturing techniques. A printed circuit board and/or other semiconductor chips may be provided on the backside of detector module 402.

A detector module 402 can also be integrated into other electrode arrays, not only the lowest electrode array of the objective lens array. Further details and alternative arrangements of a detector module integrated into an objective lens can be found in EP Application No. 20184160.8, which document is hereby referred to at least with respect to the detector module and integration of such a module in an objective lens.

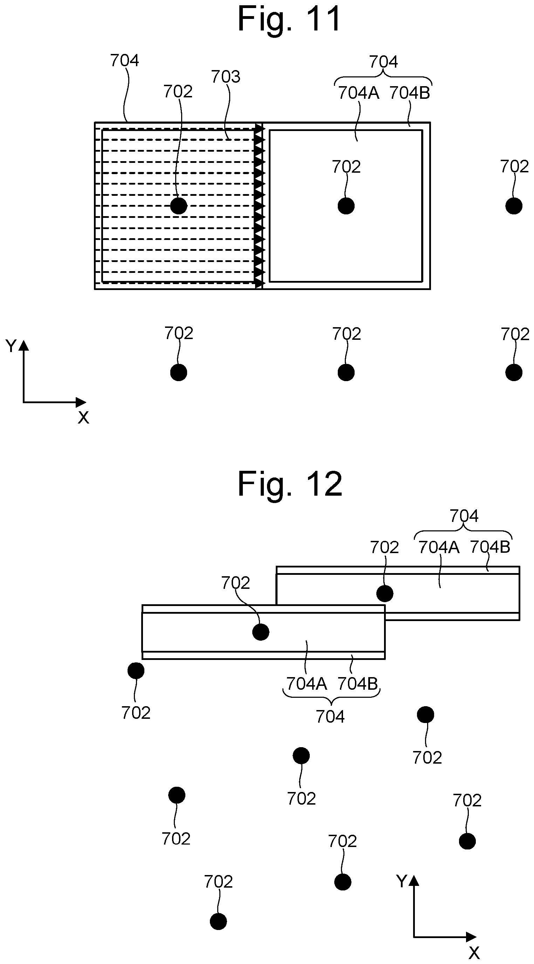

**FIGs. 11** and **12** schematically depict example methods not forming part of the claimed invention for scanning a multi-beam over a sample 208.

**FIG. 11** depicts a method that is sometimes referred to as leap and scan. Grid positions 702 depict an example geometry of a multi-beam directed onto a sample 208 by a column (e.g. an electron-optical system).

The grid positions 702 show positions of sub-beams in the multi-beam, for example when aligned e.g. after an alignment calibration. The pitch of the grid positions 702 is equal to the pitch at the sample surface of the sub-beams in the multi-beam. Each sub-beam is scanned electrostatically by the column in different directions (e.g. X and Y directions) over a pitch area 704 corresponding to the sub-beam. Two exemplary pitch areas 704 are labelled. A main scan area is labelled 704A. A border region 704B may additionally be provided to allow for beam pitch non-uniformity. The border region 704B avoids or reduces undesirable gaps between pitch areas 704 that could otherwise arise due to beam pitch non-uniformity. Broken lines 703 are shown in the leftmost example pitch area 704 to schematically represent scan lines along the X-direction. In an alternative arrangement, pitch areas may be spaced apart, preferably with minimal gap. The scan lines may be processed in sequence, one after the other, with a step in the Y direction in between each scan line. (In this context 'processing' of a sample surface is intended to mean exposing the sample surface to the beam. For example in a dynamic system, this is achieved by passing of the beam over the sample surface, where the sample and beam at its point of incidence with the surface of the sample move relative to each other in the plane of the sample; an example of this is scanning the beam over the sample surface. Thus a surface of the sample processed by the beam is a surface over which the beam has been scanned). The reference to X and Y is merely to demonstrate that the scanning occurs in two different directions that are angled with respect to each other, and may be mutually orthogonal. Sequential scan lines may follow one from the other, i.e. meander, or all scan lines may start from the side of the pitch area. The process continues until each sub-beam has processed all of its pitch area 704. The pitch areas 704 are processed by respective sub-beams in parallel. That is, the sub-beams scan their respective pitch areas 704 simultaneously. When the sub-beams have finished processing the pitch areas 704, the sample is moved to a different position (which may be referred to as a leap because of the relatively large distance involved). The process (e.g. scanning) is then repeated to process pitch areas 704 at this new position of the sample. The leap may move the sample so a different portion of the sample surface corresponds to the footprint of the multi-beam. The new position may be such as to cause scanning of a region or portion on the sample that is adjacent to the region scanned at the previous position of the sample in order to scan a large continuous area; that is the regions may be contiguous. (Such contiguous regions of the sample surface may be referred to as a scanned area.) Alternatively, the new position may be such as to cause scanning of a region on the sample that is separated from the region scanned at the previous position of the sample. The two regions may be spaced apart. The scanning of each pitch area (e.g. scanning of a sub-beam in X and stepping the sub-beam in Y) involves deflecting the sub-beams electrostatically (e.g. scanning in X and stepping in Y) over a distance that is substantially equal to the pitch of the sub-beams in the multi-beam.

**FIG. 12** depicts an alternative method that may be referred to as a continuous scan. As shown, an area of the sample surface is moved under the footprint of the multi-beam. In this approach, each sub-beam is scanned over a fraction of the sub-beam pitch (successively up or down or alternately up and down, e.g. in Y, in the orientation shown) while the sample 208 is moved orthogonally to this scanning (left or right in the orientation shown, e.g. in X), for example by the sample support 207. The fraction may be equal to the pitch of the sub-beams divided by the square root of the number of sub-beams in the multi-beam. (This is correct in case the array is square, e.g. an array of NxN sub-beams; more generally it is the pitch divided by the number of sub-beam columns in the mechanical scan direction, e.g. for an array of NxM sub-beams.) By arranging the grid positions 702 on a grid having axes that are obliquely aligned with the movement of the sample 208, it is possible to process a continuous area on the sample 208 without individual sub-beams needing to be scanning electrostatically over a large distance. Stripes are scanned by different sub-beams aligned in a row to jointly fill up a continuous area. As with the arrangement of **FIG. 11**, the scanned area may include a main scan area 704A and a border region 704B to allow for beam pitch non-uniformity.

The leap and scan method cannot easily be used where electrostatic scanning over large distances is unavailable. This may be the case in embodiments of the present disclosure where objective lenses are close to the sample, especially for objective lens arrays for example as described with reference to and shown in **FIGs. 3-5**. In some embodiments, an available electrostatic deflection range for the sub-beams will be significantly smaller than the pitch of the sub-beams at the sample surface. For example, a typical range for sub-beam pitch may be 50-500 microns (e.g. 70-150 microns) with a typical range of electrostatic deflection being in range of 0.5-2.0 micron.

The continuous scan method can be used where an available range of electrostatic scanning is limited. Scan-in/scan-out effects intrinsic to this type of scanning may, however, reduce throughput. Scan-in/scan-out effects arise because the sub-beams in one row jointly fill up the area between the row and an adjacent row. All of the sub-beams in the row thus need to be used to fill the area between the two rows. This means that the continuous scan only starts to be fully effective after the multi-beam has been scanned over a length equal to the size of the multi-beam (which may be referred to as the scan-in length). An analogous effect arises at the end of a scan line, which corresponds to the scan-out effect. Where a relatively small array of sub-beams is used the scan-in and scan-out effects may be acceptable. For example, if a $5 \times 5$ array of sub-beams with $8\mu$m pitch is used, the overall size of the multi-beam would be $40\mu$m. This would

mean that the first $40\mu$m of a continuous scan cannot be used. However, for many practical implementations of embodiments of the present disclosure much larger multi-beams are desirable, including multi-beams having sizes in the range of 1mm-15mm (e.g. around 4mm or 10.5mm). For such dimensions, in the case where a surface area of 10mm $\times$ 10mm is to be scanned per sample, an ineffective portion of processing time could represent up to 100% of an effective portion of processing time, thereby halving the throughput. Other scan-in and scan-out effects may exist in the first and last scanned region of a scanned area (i.e. of contiguous scanned areas). This is because some rows in a multi-beam arrangement may be incomplete and are contributed to complete a certain row by overlap of a scan of a contiguous area (i.e. the scan of an adjoining footprint). Thus the continuous scan only starts to be fully effective with a scan of the following, adjoining area.

Arrangements described below provide alternative methods according to the present invention that at least partially addresses one or more of the challenges described above with reference to **FIGs. 11** and **12** or other challenges.

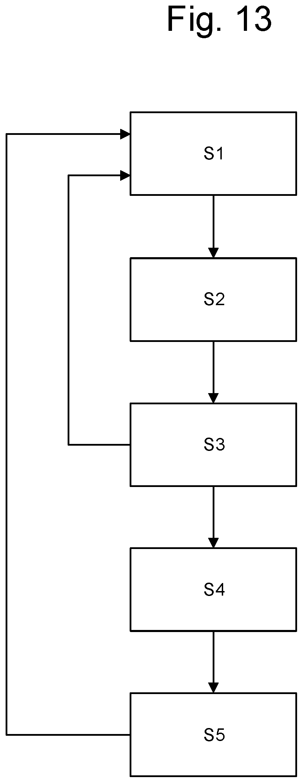

**FIG. 13** depicts a framework of a method of processing a sample 208 using a multi-beam of charged particles. The processing may comprise scanning the multi-beam over the sample 208 to cause charged particles to be emitted from the sample 208. The emitted charged particles may be detected and used to determine information about the sample 208. The method may be implemented using a charged-particle tool (which may be referred to as a charged-particle system). The charged-particle tool may comprise or consist of a charged-particle assessment tool. The charged-particle tool comprises a stage 209. The stage 209 may take any of the forms described above with reference to **FIGs. 1-3**. The stage 209 is configured to support a sample 208, for example using sample holder 207. The stage 209 may be configured to move and step the sample 208 in different directions. Movement of the stage in the path of a sub-beam may be referred to as scanning sub-beam and the sample relative to each other. The sample 208 has a sample surface. The charged-particle tool comprises a column. The column directs a multi-beam of sub-beams of charged particles onto the sample surface. The column may be configured to direct and deflect (i.e. adjust the direction of the path of a sub-beam) towards the sample. Such operation of the column on a sub-beam beam be referred to as scanning the sub-beam and the sample relative to each other. Thus scanning of a sub-beam relative to a sample can be derived to by operations of the column on the subeam and/or of the stage on the position of the sample relative to the path of the sub-beam. Thus the column may be configured to direct and scan the multi-beam of sub-beams. The multi-beam of sub-beams may be referred to as an array of sub-beams. The column may direct the multi-beam of sub-beams onto a portion of the sample surface. A part of the portion may be assigned to each sub-beam. The stage 209 and column are controlled so that the portion is scanned by the sub-beams. The column may comprise or consist of any of the electron-optical systems described above with reference to **FIGs. 1-10.**

The tool is configured to control the stage 209 and column to perform steps S1-S5 in sequence (i.e. S1 then S2 then S3 then S4 then S5). The stage 209 and column may be controlled by a controller 50, for example as described above with reference to **FIG. 1**. The controller 50 may comprise any suitable combination of data-processing hardware, firmware, software and/or computer-controlled actuators, sensors, etc. necessary for providing the desired functionality. The controller may be configured to control the column to scan and the stage 209 to move and step.

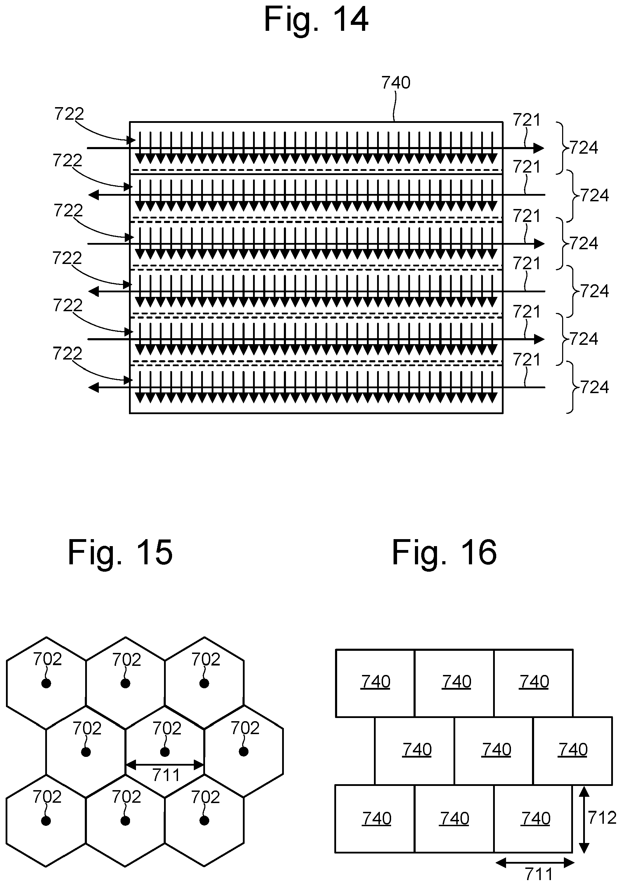

In step S1, as exemplified in **FIG. 14** for a single example sub-beam of the multi-beam, the stage 209 is used to move the sample 208 in a direction parallel to a first direction (e.g. along one of the horizontal paths 721 shown in **FIG. 14**) while the column is used to repeatedly scan the multi-beam over the sample surface in a direction parallel to a second direction (e.g. along the vertical paths 722 shown **FIG. 14**). The column may, for example, comprise an electrostatic deflector configured to perform the scanning of the multi-beam over the sample in step S1. The deflector may take any of the forms described above with reference to **FIGs. 3-10**. The deflector may be implemented as a macro scan deflector 265 as exemplified in **FIG. 3** or as a scan-deflector array. An elongate region 724 on the sample surface is thereby processed with each sub-beam. Thus, the controller may be configured to cause the sample surface to be moved (e.g. using the stage 209) relative to the array of sub-beams in a direction while the sub-beams are repeatedly scanned (e.g. by the column) over the sample surface in a different direction. An elongate region of a respective sub-beam processed area (see below) is thereby processed. For example, in the arrangement of **FIG. 14** this operation could cause the uppermost elongate region 724 to be processed by the sub-beam corresponding to the region depicted in **FIG. 14**. The paths 721 and 722 and the elongate regions 724 are depicted schematically so as to be visible in the diagram. In practice the paths 721 and 722 will be more closely spaced and many more elongate regions 724 will be processed. The widths of the elongate regions 724, which may be defined by an available range of electrostatic deflection, may typically be in the range of 0.5-2.0 microns, for example. The lengths of the elongate regions 724, which may be defined by the pitch of the sub-beams in the multi-beam, may typically be in the range of 50-500 microns, for example.

In the example of **FIG. 14**, the first and second directions are horizontal and vertical (in the plane of the page). The first and second directions are thus perpendicular to each other in this example. Thus, the movement of the sample surface relative to the array of sub-beams, which may be a continuous movement (e.g. along path 721), may be in a direction orthogonal to the scanning of the sub-beams. In other embodiments, the first and second directions are oblique relative to each other.

In step S2, the stage 209 is used to displace the sample 208 in a direction oblique or perpendicular to the first direction. In the example of **FIG. 14**, the sample 208 is displaced in a direction perpendicular to the first direction (e.g. vertically downwards in the plane of the page). This displacement of the sample 208 may be referred to as a step. The stage 209 may thus be configured to step the sample 208. The movement of the sample surface relative to the array of sub-beams along path 721 may thus be in a direction orthogonal to the stepping of the stage 209. For example, after processing the uppermost elongate region 724 in **FIG. 14** in one iteration of step S1, the stage 209 may be moved so as the bring the sub-beam in line with the next horizonal path 721 ready for the next iteration of step S1 (which movement may be referred to as a step). The stepping of a sub-beam in the direction oblique or perpendicular to the first direction between the paths 721 optionally corresponds to the dimension of the elongate region 724 perpendicular to the first direction.

In step S3, steps S1 and S2 are repeated multiple times to process further elongate regions 724 with each sub-beam. The next iteration of step S1 may thus process the elongate region 724 second from the top, the following iteration of step S1 may process the elongate region 724 third from the top, etc. The resulting plurality of processed elongate regions 724 (which may alternatively be referred to as "processed strips") defines a sub-beam processed area 740 (which may alternatively be referred to as a "processed area") for each sub-beam. Thus, multiple elongate regions 724 together define each sub-beam processed area 740. Each sub-beam processed area is associated with a respective sub-beam. Each step of the stage 209 (e.g. in step S2) may thus comprise a step relative to an elongate region 724 within the sub-beam processed area 740 associated with each sub-beam. Each step is thus small enough that each sub-beam remains within an area that will become the sub-beam processed area 740 associated with that sub-beam after each step. Step S2 may optionally be omitted after formation of a final elongate region 724 in a sub-beam processed area 740. In the arrangement depicted in **FIG. 14**, the stepping from one elongate region 724 to the next is performed downwards in the orientation of the **FIG. 14**. In other arrangements, the stepping from one elongate region 724 to the next may be performed in the opposite direction (upwards in the orientation of **FIG. 14**). The stage 209 thus displaces the sample 208 in a direction angled (i.e. oblique or perpendicular) with respect to a first direction in steps. The stage 209 displaces the sample between steps to move the sample parallel to the first direction. The column repeatedly scans the multi-beam over the sample surface in a direction different to the first direction during the movement of the sample parallel to the first direction. This repeated scanning is such that, for each step, each sub-beam scans an elongate region of a part of a portion of the sample surface assigned to the sub-beam.

The distance of displacement of the sample in step S2 after each iteration of step S1 is such that the plurality of processed elongate regions 724 in each sub-beam processed area 740 are partially overlapping (as exemplified in **FIG. 14**) or contiguous. The distance of displacement of the sample 208 by the stage 209 in the direction oblique or perpendicular to the first direction in the successive steps may thus be less than the maximum range of scanning of the multi-beam during the repeated scanning of the multi-beam parallel to the second direction. In some embodiments, the elongate regions 724 are arranged to overlap by an amount effective to compensate for imperfections such as variations in deflection strength from sub-beam to sub-beam. In some embodiments, for example, the overlap is in the range of 5%-10% of the width of the elongate regions 724. For a typical deflection range of 1.0 microns, this would correspond to an overlap in the range of 50nm-100nm.

Thus, a charged-particle tool is provided that has a column configured to direct a multi-beam of sub-beams of charged particles onto a sample surface. A portion of the sample surface corresponds to a multi-beam output region (which may alternatively be referred to simply as an "output region") of the column facing the sample surface. The multi-beam output region may correspond to a portion of the column through which the multi-beam is output towards the sample 208. The size and shape of the multi-beam output region may be defined by an objective lens array in the column. The size and shape of the multi-beam output surface may be substantially equal to that of a portion of the objective lens array closest to the sample 208. The size and shape of the portion of the sample surface may thus be defined by the objective lens array and/or portion of the objective lens array closest to the sample 208. The tool is configured to control the stage 209 and column so that the portion is scanned by the sub-beams of the multi-beam, a part of the portion being assigned to each sub-beam. The scanning may be performed as described above with reference to steps S1-S3. Thus, the stage 209 may displace the sample 208 in a direction oblique or perpendicular to a first direction in successive steps and, at each step, move the sample 208 in a direction parallel to the first direction so that, at each step, each sub-beam scans over the corresponding part in a direction parallel to the first direction. The column may repeatedly scan the multi-beam over the sample surface in a direction parallel to a second direction during the movement of the sample 208 in a direction parallel to the first direction.

The process of steps S1-S3 is depicted in **FIG. 14** for a single sub-beam only but is being performed in parallel for all of the sub-beams. That is the process of steps S1 to S3 may be performed simultaneously by each sub-beam with its respective sub-beam processed area 740. This is because the multi-beam as a whole is being scanned in step S1. The number of sub-beam processed areas 740 will thus be the same as the number of sub-beams.

In step S4, the stage is used to displace the sample by a distance equal to at least twice a pitch at the sample surface of the sub-beams in the multi-beam. This displacement may be referred to as a leap displacement. The distance of displacement may be much larger than twice the pitch, optionally as large as an overall size of the multi-beam at the sample surface (as discussed in further detail below). The distance of displacement may even be of the same order of size at the sample (e.g. wafer). The different multibeam sized areas do not have to be adjacent. For some applications this may be desirable (e.g. to scan a large continuous area). For other applications, it may be desired to scan different areas of the sample. Thus, the sample is moved so that a new region of the sample surface is moved under a multi-beam output region of the column. Typically, the movement for a contiguous new region is either in the first direction or the second direction. However, the movement can be in any direction to any region of the sample surface.

In step S5, steps S1-S4 are repeated from the new location of the sample after the displacement of step S4. Thus, the scanning of the multi-beam in the successive steps (e.g. steps S1-S3) may be performed plural times to form a corresponding plurality of sub-beam processed areas with each sub-beam, and the stage 209 may perform a leap displacement (e.g. step S4) after each performance of the successive steps.

In some embodiments, a maximum range of scanning of the multi-beam by the column in step S1 (e.g. during the repeated scanning of the multi-beam by the column in the direction parallel to the second direction) is less than, optionally less than 50% of, optionally less than 10% of, optionally less than 5% of, optionally less than 2% of, optionally less than 1% of, optionally less than 0.5% of, a minimum pitch at the sample surface of the sub-beams in the multi-beam. As described above with reference to **FIGs. 11** and **12**, the sub-beams in the multi-beam may be provided in a grid defined by grid positions 702. The pitch of the sub-beams may refer to the pitch of the grid positions 702. The pitch along different principle axes of the grid may be different. The minimum pitch may be the pitch along the principle axis that has the smallest pitch. Unlike arrangements such as that described above with reference to **FIG. 11** (referred to as a leap and scan method), the present embodiment may thus be applied where a maximum range of scanning is smaller than the pitch of the sub-beams. The approach may thus be applied efficiently to embodiments having an objective lens array assembly such as those described above with reference to **FIGs. 1-10.**

In some embodiments, each performance of steps S1-S3 defines at least one group of sub-beam processed areas 740 that are partially overlapping or contiguous with respect to each other, thereby processing a continuous region larger than any individual sub-beam processed area 740. In an embodiment, this is achieved by arranging for the distance of movement of the sample in step S1 to be substantially equal to a pitch at the sample surface of the sub-beams in the multi-beam in the first direction. Thus, the distance of movement of the sample 208 in the direction parallel to the first direction in each step may be substantially equal to a pitch at the sample surface of the sub-beams in the multi-beam in the first direction. Sub-beam processed areas 740 formed at the same time by neighboring sub-beams thus overlap or are contiguous with each other.

**FIGs. 15** and **16** depict an example relationship between a geometry of a grid of sub-beams in a multi-beam (defined by grid positions 702 of the sub-beams) and a geometry of sub-beam processed areas 740 obtained by performing the method of **FIG. 13**. This example demonstrates that the symmetry of the grid of sub-beams does not need to be the same as the symmetry of the sub-beam processed areas 740. In the example shown, the sub-beams are provided on a hexagonal grid (i.e. a grid having hexagonal symmetry), while the sub-beam processed areas 740 are rectangular. Continuous coverage of the sample surface parallel to the first direction (horizontally in the orientation depicted) is achieved by arranging for the distance 711 of movement of the sample 208 in step S1 to be equal to a pitch 711 of the grid of sub-beams in the first direction (i.e. the width of the tessellating hexagons centered on the grid positions 702). The length of the elongate regions and/or of the sub-beam processed areas associated with each sub-beam may thus be equal to the pitch 711. Continuous coverage of the sample surface parallel to the second direction (vertically in the orientation depicted) is achieved by arranging for the cumulative distance 712 of the displacements in step S2 (e.g. stepping of the path 724 over the processed area of the sample surface, which in this example is performed in a direction parallel to the second direction) to be equal to a pitch 712 of the grid of sub-beams in the second direction. That is, the pitch of the grid of sub-beams in the second direction may be equal to the cumulative distance of the width of the elongate regions in the direction of displacements in step S2, for example parallel to the second direction. The pitch of the grid of sub-beams may be determined by the number of elongate regions over the processed area for the respective sub-beam; for example in view of the width of the elongate regions for example in the second direction. The number of elongate regions over the processed area of a sub-beam may be one more than the number of steps of the path 724 over the processed area of the sample surface.

In a specific example case where the sub-beams are provided in a hexagonal array with 70 micron pitch, each sub-beam would be scanned over a rectangular area (defining the sub-beam processed area 740) of $70\,\mu m \times 60.6\,\mu m$ to scan a continuous area (with the 60.6 arising because $0.5 \times \sqrt{3} \times 70 = 60.6$ ). In an example case where the field of view of an objective lens is 1 micron, to cover one area of $70\,\mu m \times 60.6\,\mu m$ would require 60 scans of elongate regions 724 that are $1.01\,\mu m$ wide and $70\,\mu m$ long. Thus the sub-beam processed area, such as the rectangular area ,of the surface associated to a sub-beam, has dimension in the second direction equal to the cumulative distance of the width of the elongate regions over the processed area of a sub-beam in stepping direction, e.g. of Step S2, for example in the second direction . Note: in a different arrangement the sub-beams may be provided in an array having a grid of a different shape, for example parallelogram, rhombus, rectangular or square. For each shape of beam arrangement, the sub-beam processed areas 740 may be rectangular.

In some embodiments, the displacement of the sample in step S2 is parallel to the second direction (i.e. parallel to the direction of scanning of the multi-beam over the sample in step S1).

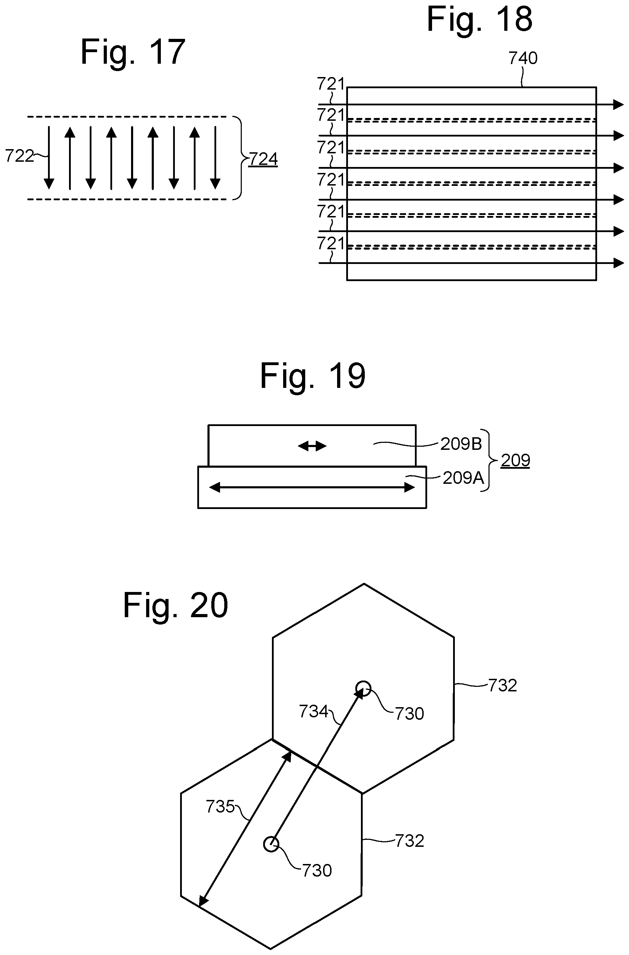

In some embodiments, the paths 722 of the scans of the multi-beam over the sample 208 by the column in step S1 are all in the same direction (i.e. the scans of the multi-beam over the sample surface in the direction parallel to the second direction during the movement of the sample in the direction parallel to the first direction may all be performed in the same direction), as exemplified in **FIG. 14**. In such an arrangement the direction of the paths 722 of the scans may be referred to as stepped. This approach may promote uniformity of the scanning process from one scan to the next scan and/or may allow errors to be more easily corrected for. For example, in the case where the scans by the column during S1 are all performed in the same direction (i.e. stepped) a mismatch in the synchronization between the deflector and the detector may result in a shift of the pattern. Such a shift can be corrected for in downstream processing of the image. However, in the case where the scans by the column during S1 are performed in alternating directions a mismatch in the synchronization between the deflector and the detector may result in a blurring of the pattern (as alternating pixel rows of the image are shifted up and down). This blurring is more difficult to correct for. In other embodiments, as exemplified in **FIG. 17**, the scans of the multi-beam over the sample 209 by the column in step S1 are performed in alternating directions (e.g. in the sequence up-down-up-down-up etc. in the orientation shown in **FIG. 17**). In such arrangement the direction of the scan paths 722 may be referred to as continuous and meandering. Arranging for the scan paths 722 to be continuous may reduce bandwidth requirements in comparison to the stepping approach.

In some embodiments, as exemplified in **FIG. 14**, the movements of the sample 208 in step S1 during the repeated performance of steps S1 and S2 are performed in alternating directions (e.g. such that paths 721 follow the sequence right-left-right-left-right etc. in the orientation shown in **FIG. 14**). In such arrangement the direction of sequential paths 721 may be referred to as continuous and meandering. This approach minimizes the overall distance moved by the sample 208. In other embodiments, as exemplified in **FIG. 18**, the movements of the sample 208 in step S1 during the repeated performance of steps S1 and S2 are all in the same direction, for example across the sub-beam pitch processed area 740. In such arrangement the direction of sequential paths 721 may be referred to as stepped.

In some embodiments, as exemplified in **FIG. 19**, the stage 209, for example as depicted in **FIG. 2**, comprises independently actuatable long-stroke and short-stroke stages 209A and 209B. A maximum range of motion of the long-stroke stage 209A is longer than a maximum range of motion of the short-stroke stage 209B. In some embodiments, the short-stroke stage 209B is supported by the long-stroke stage 209A. Movement of the long-stroke stage 209A causes a corresponding movement of the short-stroke stage 209B without any actuation of the short-stroke stage 209B. The long-stroke stage 209A may be configured to provide relatively coarse position control over relatively long distances. The short-stroke stage 209B may be configured to provide finer position control over shorter distances. In an embodiment the range of motion provided by a short stroke stage may be 1 mm or less, i.e. a displacement 0.5 mm or less in magnitude with respect to the position of the long-stroke stage.

In some embodiments, the movement of the sample 208 in steps S1-S3 (e.g. during the scanning of the multi-beam in the successive steps) is performed exclusively using the short-stroke stage 209B. The long-stroke stage 209A may thus remain in the same position and/or unactuated while all of the elongate regions 724 defining the sub-beam processed areas 740 of the multi-beam are formed for a single execution of steps S1-S3. This approach, in using exclusively the short stroke for movement during scanning, ensures accurate and repeatable sample motion, thereby ensuring that the sub-beam processed areas 740 are processed accurately and reliably.

In some embodiments, the movement of the sample 208 in step S4 (e.g. during each leap displacement) is performed preferably exclusively using the long-stroke stage 209B. Such movement may be achieved quickly without disturbing the relative positioning of the short stroke relative to the long stroke. In other embodiments the short stroke moves also the sample during a leap displacement by the long stroke so that the scanning of the multi-beam in the successive steps over the new portion of the sample can be recommenced, i.e. after the leap displacement. Beneficially movement at the new position can recommence to start processing of the new portion of the sample without involving the short stroke in positioning the sample surface relative to the beam path.

In some embodiments, the displacement of the sample in step S4 (e.g. during each leap displacement) is relative to a facing surface of the electron-optical column intended to face a sample, such as a detector. Such a facing surface may face any feature of a stage orientated on the stage and configured to be exposable to the beam during operation, such as a surface of the stage away from the sample and an electron-optical sensor. Such a detector of the column may be the element of an electron-optical column positioned closest in use to a sample. The sample facing surface of the column and the sample may be positioned proximate to each other during processing so as to optimize the performance of the detector. The sample may be positioned relative to the column to optimize parameters of the sub-beams such as focus. In the following description, positioning of the sample is used although this should also be read as movement of at least the facing surface of the column because the detector may be actuatable, see 2019P00407EP02 which is hereby referred to at least so far as the actuatable detector.

In some embodiments, the displacement of the sample in step S4 (e.g. during each leap displacement) is performed with the sample positioned further away from the column than during the movement of the sample in steps S1-S3 (e.g. during the scanning of the multi-beam in the successive steps). This may be achieved for example by using the stage 209 to move the sample 208 away from the column (e.g. by lowering the sample 208) and/or by using the column to move a portion of the column such as a detector away from the sample 208 (e.g. by raising the detector). Alternatively expressed, the clearance between the sample and the column may be reduced between leap displacements for example by raising the sample, lowering at least an element of the column such as the detector. Relative movement is thus provided between the sample 208 and the column to increase the distance between them. The relative movement may be vertical and/or parallel with the electron-optical axis of the column. The relative movement may be performed before and/or after the displacement of the sample in step S4. Thus, the movement of the sample 208 through the sequence of leap displacements may comprise relatively displacing the sample along the beam path. In particular, the relative displacement of the sample along the beam path may comprise increasing the distance between the sample and the column before moving the sample in a leap displacement. The relative displacement of the sample 208 along the beam path may further comprise decreasing the distance between the sample 208 and the column after the moving of the sample in the leap displacement.

Performing the displacement of the sample in step S4 with the sample positioned further away from the column than during movement of the sample in steps S1-S3 reduces the risk of collision between the sample 208 and the column, especially part of the column proximate to the sample. The approach may reduce the risk of collision with elements of the column which may in operation be proximate to the sample, for example, with a detector in the column. The detector may be configured to detect charged particles emitted from the sample 208 and may need to be provided relatively close to the sample 208 during the scanning of the sub-beams over the sample surface, for example facing the surface; see for example the detector described with reference to and as shown in **FIGs. 7-10.** The distance between the sample and the facing surface of the column may be less than 300 microns, less than 200 microns, less than 100 microns, between 50 and 5 microns or between 30 and 10 microns. The distance between sample and facing surface of the column may be between 1 mm and 100 micron during the displacement of the sample in step S4, e.g. during leap displacement. Such reduced risk of collision may be beneficial: during the relatively long movements involved in step S4; and/or in reducing the need for sophisticated sensor systems e.g. to detect the relative positions of the sample of the part of the column proximate to the sample; and/or in reducing the need for control techniques to reduce the risk of collisions during such a long sample movement. Such movements may be between 1mm and 300mm.

As exemplified in **FIG. 20**, a footprint 732 of the column may be defined as the smallest bounding box on the sample surface that surrounds all of the sub-beam processed areas. Thus, the footprint 732 has an outline or a boundary which corresponds to (e.g. is the same as) an outline of the smallest bounding box on the sample surface that surrounds all of the sub-beam processed areas. The sub-beam processed areas surrounded by the smallest bounding box are the sub-beam processed areas formed at a single position (which may be referred to as a single nominal processing position) of the sample between leap displacements. The single position may correspond to a single position of the long-stroke stage 209A. The single position may correspond to a single performance of the scanning of the multi-beam in the successive steps, such as from a single performance of steps S1-S3 (e.g. for one position of the long-stroke stage 209A). In arrangements comprising steps S1-S3, the footprint 732 of the column may thus be defined to have an outline that corresponds to the outline of the smallest bounding box on the sample surface that surrounds all of the sub-beam processed areas of a single performance of steps S1-S3. The size and shape of the footprint of the column may be defined by the size and shape of the multi-beam output surface of the column (e.g. a portion of the objective lens array closest to the sample 208). In some embodiments, the distance of displacement of the sample 208 in step S4 (indicated schematically by the arrow 734 leading from the center 730 of one footprint 732 to the center 730 of another footprint 732) is substantially equal to or greater than a dimension 735 of the footprint parallel to the direction of the movement. The direction of the movement in step S4 may be parallel to the first direction (corresponding to the direction of movement of the sample 208 in step S1) or parallel to the second direction (corresponding to a possible direction of movement of the sample 208 in step S2) or, as exemplified in **FIG. 20**, in a different direction.

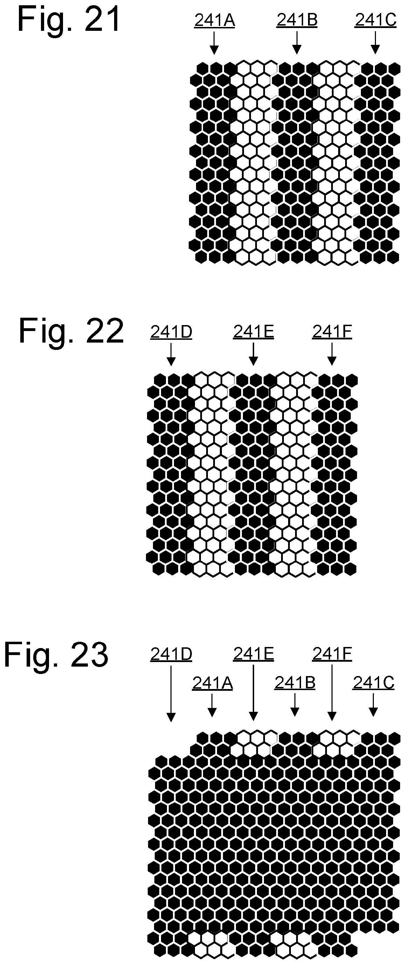

In some embodiments, as exemplified in **FIGs. 21-23**, a performance of steps S1-S3 (e.g. each performance of the scanning of the multi-beam in the successive steps) defines plural groups of sub-beam processed areas. Each group of sub-beam processed areas may be located in a respective portion of a footprint 732. The locations 241A-F of such groups (hereinafter referred to as 'group-locations' 241A-F) are represented schematically in **FIGs. 21-23** as filled-in hexagons.

Each filled-in hexagon represents a region corresponding to a single sub-beam (on a hexagonal grid). The hexagon shapes are hexagonal because of the symmetry of the multi-beam. Each hexagon represents a portion of the multi-beam of sub-beams (which may also be referred to as an array of sub-beams) that is assigned to a single sub-beam.

Tessellating shapes other than hexagons would be appropriate for multi-beams having different symmetries. As described above with reference to **FIGs. 15 and 16**, the sub-beam processed areas at these group-locations will typically be square or rectangular due to the way the sub-beams are scanned over the sample. The shape of the sub-beam processed area may thus differ from the shape of the portion of the multi-beam assigned to each sub-beam. The area of the sub-beam processed area associated with each sub-beam may be equal to the area of the portion of the multi-beam assigned to the sub-beam.

The unfilled hexagons in **FIGs. 21** and **22** represent regions where no sub-beams are present. Such a region of the footprint corresponding to unfilled hexagons, or cells, may be referred to as an unfilled footprint portion. Such an unfilled footprint portion may extend across the footprint in a direction, for example from one side of the footprint to an opposing side. This may be desirable, for example, to allow space for thermal conditioning, e.g. cooling, arrangements or other features in the column (e.g. spacers to enhance mechanical stiffness; and/or data signal lines and/or electrical power supply lines to/from a detector or an electron-optical element). See patent publication EP2638560 published on 18 September 2013 which is hereby referred to with respect to an array of apertures which incorporates a thermal conditioning arrangement.

When steps S1-S3 are performed, a sub-beam processed area will be defined at each region on the sample surface corresponding to a filled-in hexagon. Thus, each group of sub-beam processed areas is represented by a group of contiguous filled in hexagons (even though the sub-beam processed areas themselves will typically be square or rectangular). The sub-beam processed areas within each group are partially overlapping or contiguous with respect to each other and separated from sub-beam processed areas of other groups. The sub-beam processed areas in each group are thus interconnected and may be referred to as interconnected sub-beam processed areas or contiguous sub-beam processed areas (or as 'interconnected areas'). The groups are separated from each other. Sub-beam processed areas in each group are thus separated from (not interconnected with) the sub-beam processed areas of each other group. In the example shown, three groups are present at three corresponding regions for each performance of steps S1-S3 (241A-C in **FIG. 21** and 241D-F in **FIG. 22**).

The displacement of the sample in step S4 (e.g. a leap displacement) is such that the groups of sub-beam processed areas from one performance of steps S1-S3 (e.g. scanning of the multi-beam in the successive steps) are positioned relative to the groups of sub-beam processed areas from another performance of steps S1-S3 so as to form at least one enlarged, continuous group of sub-beam processed areas. The enlarged group comprises two or more of the groups of sub-beam processed areas. This may be achieved for example, as exemplified in **FIGs. 21-23** by arranging for the displacement of the sample 208 in step S4 to be such that the enlarged group is formed by interleaving the groups generated from the different performances of steps S1-S3.

In the example shown, three groups of sub-beam processed areas are formed in a first execution of steps S1-S3. The three groups are at group-locations 241A-C as depicted in **FIG. 21**. The sample 208 is then moved, e.g. stepped, in step S4 to a new position (e.g. a further leap displacement). This movement results in a second execution of steps S1-S3 defining more sub-beam processed areas at different group-locations 241D-F of the sample surface as depicted in **FIG. 22**. Each execution of steps S1-S3 is thus performed with the stage at a different nominal processing position. This may be achieved by the stage performing a sequence of leap displacements to move the sample 208 relative to the column through a corresponding sequence of nominal processing positions (which may be referred to simply as processing positions, although some small movement of the stage may occur at each such processing position as explained below).

At each nominal processing position, the multi-beam is scanned over the sample surface to process a sub-beam processed area with each sub-beam. The resulting sub-beam processed areas comprise plural groups of interconnected sub-beam processed areas (which may be referred to as contiguous sub-beam processed areas). The groups are separated from each other. Small movements of the stage may occur while the stage is at the nominal processing position (e.g. the small movements described above with reference to steps S1-S3).

Each leap displacement is longer, typically many times longer, than any of the small movements made at each nominal processing position. The leap displacement is equal to or greater than twice a pitch at the sample surface of the multi-beam, optionally many times longer. In practice, an embodiment has a leap displacement many times longer, for example 10 to 100times the pitch. The corresponding contiguous region of interconnected sub-beam processed areas may be a corresponding number of columns of sub-beam processed areas wide, for example 10 to 100. As mentioned above, in some arrangements the leap displacement is between 1mm and 300mm. The leap displacement may typically be towards the lower end of the range in arrangements where interleaving is used, for example around 10 times the beam pitch. Where no interleaving is used, the leap displacement may also be towards the lower end of the range, but may also be larger.

In some arrangements, the nominal processing positions are such that at least one of the groups of interconnected sub-beam processed areas formed at one of the nominal processing positions is interleaved between at least two of the groups of interconnected sub-beam processed areas formed at a different one of the nominal processing positions. This is exemplified in **FIG. 21-23** and described in further detail below with reference to the case where steps S1-S3 are performed at each of the nominal processing positions. In other arrangements, steps other than steps S1-S3 may be used to produce the groups of interconnected sub-beam processed areas at each nominal processing position.

In the example of **FIGs. 21-23,** the group-locations 241A-C shown in **FIG. 21** are displaced relative to the group-locations 241D-F shown in **FIG. 22** so as to be interleaved. In this example, the cumulative effect of the two executions of steps S1-S3 results in groups of sub-beam processed areas being defined as shown in **FIG. 23**. (Note, **FIG. 23** shows that the first execution is lower, e.g. displaced orthogonally to the movement of the sample between the two executions by two cells of the grid. This detail is not required and is only included so that the different group-locations of each execution can be noted.) The groups of sub-beam processed areas are thus joined together to form an enlarged group of sub-beam processed areas. The sub-beam processed areas in the enlarged group are interconnected and include at least one interleaved group. The enlarged group of sub-beam processed areas (e.g. formed by interleaving smaller groups of sub-beam processed areas) allows continuous coverage of a large region of the sample surface even where features, such as cooling arrangements, are provided that prevent a correspondingly complete coverage of the processing area by sub-beams of the multi-beam. To enable the interleaving, the width of the groups of sub-beam processed areas may be similar to the separations between the groups. Thus a group of sub-beam processed areas and the surface of the sample corresponding to an unfilled footprint portion may have similar width, for example two or more sub-beam processed areas wide. Thus a group sub-beam processed areas may map onto a previously unfilled footprint portion, enabling the groups of sub-beam processed areas to interleave and permit continuous coverage of the sample surface. Thus a total width of the unfilled footprint portions may comprise up to fifty percent of the footprint width. In embodiments involving such interleaving, the distance of displacement of the sample in a leap displacement (e.g. in step S4) will be less than (smaller than) a dimension of the footprint parallel to the direction of the movement (e.g. in contrast to the situation described above with reference to **FIG. 20**). Thus such a footprint may have a width of six or more times the pitch of the sub-beam processing areas. Such an arrangement would have two groups either side of an unfilled portion. In a different arrangement, the footprint may be dimensioned to be as many pitches of the sub-beam processed area as desired, with as many groups as required. The number of unfilled footprint portions may correspond to the number of groups or be one less.

Thus the array of sub-beams, for example of the multi-beam, may have two dimensions, for example in which the sub-beams are arranged. In one of the dimension of the array, the array comprises at least three preferably at least four sub beams. The at least four sub-beams are comprised in at least two groups and at least one unfilled portion (or unfilled footprint portion). The unfilled portions are each between, or interleaved between, two of the groups. The groups and unfilled portion extend across the array in the other dimension of the array for example with a dimension multiple sub-beam pitches large for example more than two, three, five, ten, fifty, one hundred or more.

An assessment tool according to an embodiment of the disclosure may be a tool which makes a qualitative assessment of a sample (e.g. pass/fail), one which makes a quantitative measurement (e.g. the size of a feature) of a sample or one which generates an image of map of a sample. Examples of assessment tools are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The electron-optical column 40 may be a component of an assessment tool; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector.

References to elements being aligned along a beam path or sub-beam path are understood to mean that the respective elements are positioned along the beam path or sub-beam path.

References to optics are understood to mean electron-optics.

Reference in the specification to control of the electron-optical elements such as control lenses and objective lenses is intended to refer to both control by the mechanical design and set operating applied voltage or potential difference, i.e. passive control as well as to active control, such as by automated control within the electron-optical column or by user selection. A preference for active or passive control should be determined by the context.

Reference to a component or system of components or elements being controllable to manipulate a charged particle beam in a certain manner includes configuring a controller or control system or control unit to control the component to manipulate the charged particle beam in the manner described, as well optionally using other controllers or devices (e.g. voltage supplies and or current supplies) to control the component to manipulate the charged particle beam in this manner. For example, a voltage supply may be electrically connected to one or more components to apply potentials to the components, such as in a non-limited list the control lens array 250, the objective lens array 241, the condenser lens 231, correctors, collimator element array 271 and scan deflector array 260, under the control of the controller or control system or control unit. An actuatable component, such as a stage, may be controllable to actuate and thus move relative to another component such as the beam path using one or more controllers, control systems, or control units to control the actuation of the component.

The present invention may be embodied as a computer program. For example, a computer program may comprise instructions to instruct the controller 50 to perform the following steps. The controller 50 controls the electron beam apparatus to project an electron beam towards the sample 208. In an embodiment the controller 50 controls at least one electron-optical element (e.g. an array of multipole deflectors or scan deflectors 260, 265) to operate on the electron beam in the electron beam path. Additionally or alternatively, in an embodiment the controller 50 controls at least one electron-optical element (e.g the detector 240) to operate on the electron beam emitted from the sample 208 in response to the electron beam. Additionally or alternatively, the computer program may comprise instructions to instruct the controller 50 to provide any of the functionality described above with reference in particular to **FIG. 13-23** including control of the column to scan and the stage 209 to move and step.

References to upper and lower, up and down, above and below should be understood as referring to directions parallel to the (typically but not always vertical) up-beam and down-beam directions of the electron beam or multi-beam impinging on the sample 208. Thus, references to up beam and down beam are intended to refer to directions in respect of the beam path independently of any present gravitational field.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope of the invention being indicated by the following claims and clauses.

**Claims**

1. A method of processing a sample (208) using a multi-beam of charged particles provided by a column configured to direct a grid of sub-beams of charged particles onto a sample surface of a sample, the method comprising: performing the following steps in sequence:

   (a) move the sample (208) in a direction parallel to a first direction a distance in the first direction while using the column to repeatedly scan the multi-beam over the sample surface in a direction parallel to a second direction, thereby processing an elongate region (724) on the sample surface with each sub-beam, wherein the first direction and the second direction are perpendicular or oblique relative to each other;
   (b) displace the sample (208) in a direction oblique or perpendicular to the first direction; and
   (c) repeat steps (a) and (b) multiple times to process further elongate regions (724) with each sub-beam, the resulting plurality of processed elongate regions (724) defining a sub-beam processed area (740) for each sub-beam, wherein the distance of displacement of the sample in (b) is such that the plurality of processed elongate regions (724) in each sub-beam processed area (740) are partially overlapping or contiguous.

2. The method of claim 1, wherein the distance in the first direction is substantially equal to a pitch at the sample surface of the sub-beams in the multi-beam.

3. The method of claim 1 or 2, wherein a maximum range of scanning of the multi-beam by the column in (a) is less than a minimum pitch at the sample surface of the sub-beams in the multi-beam.

4. The method of any preceding claim, wherein a performance of (a)-(c) defines at least one group of sub-beam processed areas (740) that are partially overlapping or contiguous with respect to each other.

5. The method of any preceding claim, wherein the displacement of the sample (208) in (b) is parallel to the second direction.

6. The method of any preceding claim, wherein the scans of the multi-beam over the sample (208) by the column in (a) are all performed in the same direction.

7. The method of any of claims 1 to 5, wherein the scans of the multi-beam over the sample (208) by the column in (a) are all performed in alternating directions.

8. The method of any preceding claim, wherein the movements of the sample (208) in (a) during the repeated performance of (a) and (b) are all in the same direction.

9. The method of any preceding claim, further comprising performing the following steps in sequence after steps (a)-(c) wherein after steps (a)-(c) comprises after the sub-beam processed area (740) for each sub-beam has been defined by the plurality of processed elongate regions (724) desirably by the respective sub-beam:

   (d) displace the sample (208) by a distance equal to at least twice a pitch at the sample (208) surface of the sub-beams in the multi-beam; and
   (e) repeat (a)-(d).

10. The method of claim 9, wherein the sample (208) is moved using independently actuatable long-stroke and short-stroke stages (209A, 209B), a maximum range of motion of the long-stroke stage (209A) being longer than a maximum range of motion of the short-stroke stage (209B).

11. The method of claim 10, wherein the sample (208) is moved in steps (a)-(c) using the short-stroke stage (209B), preferably exclusively.

12. The method of claim 10 or 11, wherein the sample (208) is moved in step (d) using the long-stroke stage (209A), preferably exclusively.

13. The method of any of claims 9 to 12, wherein the displacement of the sample (208) in (d) is performed with the sample (208) positioned further away from the column than during the movement of the sample (208) in (a)-(c).

14. The method of any of claims 9 to 13, wherein:

   where a footprint of the column is defined as the smallest bounding box on the sample surface that surrounds all of the sub-beam processed areas (740) from a performance of (a)-(c), the distance of displacement of the sample (208) in (d) is substantially equal to or greater than a dimension of the footprint parallel to the direction of the movement.

**15.** A multi-beam charged-particle system, comprising:

a stage (209) for supporting a sample (208) having a sample surface; and

a column configured to direct a grid of subbeams of charged particles onto the sample surface, wherein the system is configured to control the stage (209) and column to perform the following in sequence:

(a) use the stage (209) to move the sample (208) in a direction parallel to a first direction a distance in the first direction while using the column to repeatedly scan the multibeam over the sample surface in a direction parallel to a second direction, thereby processing an elongate region (724) on the sample surface with each sub-beam, wherein the first direction and the second direction are perpendicular or oblique relative to each other;

(b) use the stage (209) to displace the sample (208) in a direction oblique or perpendicular to the first direction; and

(c) repeat (a) and (b) multiple times to process further elongate regions (724) with each sub-beam, the resulting plurality of processed elongate regions (724) defining a sub-beam processed area (740) for each sub-beam, wherein the distance of displacement of the sample in (b) is such that the plurality of processed elongate regions (724) in each sub-beam processed area (740) are partially overlapping or contiguous.

**Patentansprüche**

**1.** Ein Verfahren zum Bearbeiten einer Stichprobe (208) unter Verwendung eines Mehrfachstrahls von geladenen Teilchen, der durch eine Säule bereitgestellt wird, welche konfiguriert ist, um ein Raster von Teilstrahlen von geladenen Teilchen auf eine Stichprobenoberfläche einer Stichprobe zu richten, wobei das Verfahren Folgendes beinhaltet: sequenzielles Durchführen der folgenden Schritte:

(a) Bewegen der Stichprobe (208) in einer zu einer ersten Richtung parallelen Richtung über eine Distanz in der ersten Richtung, während die Säule verwendet wird, um den Mehrfachstrahl in einer zu einer zweiten Richtung parallelen Richtung wiederholt über die Stichprobenoberfläche zu streichen, wodurch mit jedem Teilstrahl eine längliche Region (724) auf der Stichprobenoberfläche bearbeitet wird, wobei die erste Richtung und die zweite Richtung relativ zueinander senkrecht oder schräg sind;

(b) Verschieben der Stichprobe (208) in einer zu der ersten Richtung schrägen oder senkrechten Richtung; und

(c) mehrfaches Wiederholen der Schritte (a) und (b), um mit jedem Teilstrahl weitere längliche Regionen (724) zu bearbeiten, wobei die resultierende Vielzahl von bearbeiteten länglichen Regionen (724) für jeden Teilstrahl einen teilstrahlbearbeiteten Bereich (740) definiert, wobei die Verschiebungsdistanz der Stichprobe in (b) derart ist, dass die Vielzahl von bearbeiteten länglichen Regionen (724) in jedem teilstrahlbearbeiteten Bereich (740) sich teilweise überlappt oder direkt aneinander angrenzt.

**2.** Verfahren gemäß Anspruch 1, wobei die Distanz in der ersten Richtung im Wesentlichen gleich einem Abstandsmaß der Teilstrahlen in dem Mehrfachstrahl an der Stichprobenoberfläche ist.

**3.** Verfahren gemäß Anspruch 1 oder 2, wobei eine maximale Reichweite des Streichens des Mehrfachstrahls durch die Säule in (a) kleiner als ein minimales Abstandsmaß der Teilstrahlen in dem Mehrfachstrahl an der Stichprobenoberfläche ist.

**4.** Verfahren gemäß einem der vorhergehenden Ansprüche, wobei eine Durchführung von (a)-(c) mindestens eine Gruppe von teilstrahlbearbeiteten Bereichen (740) definiert, die sich teilweise überlappen oder in Bezug aufeinander direkt aneinander angrenzen.

**5.** Verfahren gemäß einem der vorhergehenden Ansprüche, wobei die Verschiebung der Stichprobe (208) in (b) parallel zu der zweiten Richtung erfolgt.

**6.** Verfahren gemäß einem der vorhergehenden Ansprüche, wobei alle Streichvorgänge des Mehrfachstrahls über die Stichprobe (208) durch die Säule in (a) in der gleichen Richtung durchgeführt werden.

**7.** Verfahren gemäß einem der Ansprüche 1 bis 5, wobei alle Streichvorgänge des Mehrfachstrahls über die Stichprobe (208) durch die Säule in (a) in wechselnden Richtungen durchgeführt werden.

**8.** Verfahren gemäß einem der vorhergehenden Ansprüche, wobei alle Bewegungen der Stichprobe (208) in (a) während der wiederholten Durchführung von (a) und (b) in der gleichen Richtung durchgeführt werden.

**9.** Verfahren gemäß einem der vorhergehenden Ansprüche, das ferner das sequenzielle Durchführen der folgenden Schritte nach den Schritten (a)-(c) beinhaltet, wobei nach den Schritten (a)-(c) beinhaltet, nachdem der teilstrahlbearbeitete Bereich (740) für jeden Teilstrahl durch die Vielzahl von bearbeiteten länglichen Regionen (724) definiert worden ist, wünschenswerterweise durch den jeweiligen Teilstrahl:

(d) Verschieben der Stichprobe (208) um eine Distanz, die gleich dem mindestens Zweifachen eines Abstandsmaßes der Teilstrahlen in dem Mehrfachstrahl an der Stichproben(208)-Oberfläche ist; und
(e) Wiederholen von (a)-(d).

10. Verfahren gemäß Anspruch 9, wobei die Stichprobe (208) unter Verwendung eines Langhub- und eines Kurzhubtisches (209A, 209B), die unabhängig voneinander betätigbar sind, bewegt wird, wobei eine maximale Reichweite der Bewegung des Langhubtisches (209A) länger als eine maximale Reichweite der Bewegung des Kurzhubtisches (209B) ist.

11. Verfahren gemäß Anspruch 10, wobei die Stichprobe (208) in den Schritten (a)-(c) unter bevorzugt ausschließlicher Verwendung des Kurzhubtisches (209B) bewegt wird.

12. Verfahren gemäß Anspruch 10 oder 11, wobei die Stichprobe (208) in Schritt (d) unter bevorzugt ausschließlicher Verwendung des Langhubtisches (209A) bewegt wird.

13. Verfahren gemäß einem der Ansprüche 9 bis 12, wobei bei der Durchführung der Verschiebung der Stichprobe (208) in (d) die Stichprobe (208) weiter von der Säule entfernt positioniert ist als während der Bewegung der Stichprobe (208) in (a)-(c).

14. Verfahren gemäß einem der Ansprüche 9 bis 13, wobei:

wenn ein Footprint der Säule als die kleinste Begrenzungslinie auf der Stichprobenoberfläche definiert ist, welche alle teilstrahlbearbeiteten Bereiche (740) aus einer Durchführung von (a)-(c) umgibt,
die Verschiebungsdistanz der Stichprobe (208) in (d) im Wesentlichen gleich oder größer als eine Abmessung des Footprints parallel zu der Bewegungsrichtung ist.

15. Ein Mehrstrahl-System für geladene Teilchen, das Folgendes beinhaltet:

einen Tisch (209) zum Tragen einer Stichprobe (208), die eine Stichprobenoberfläche aufweist; und
eine Säule, die konfiguriert ist, um ein Raster von Teilstrahlen von geladenen Teilchen auf die Stichprobenoberfläche zu richten, wobei das System konfiguriert ist, um den Tisch (209) und die Säule zum sequenziellen Durchführen von Folgendem zu steuern:

(a) Verwenden des Tisches (209) zum Bewegen der Stichprobe (208) in einer zu einer ersten Richtung parallelen Richtung über eine Distanz in der ersten Richtung, während die Säule verwendet wird, um den Mehrfachstrahl in einer zu einer zweiten Richtung parallelen Richtung wiederholt über die Stichprobenoberfläche zu streichen, wodurch mit jedem Teilstrahl eine längliche Region (724) auf der Stichprobenoberfläche bearbeitet wird, wobei die erste Richtung und die zweite Richtung relativ zueinander senkrecht oder schräg sind;
(b) Verwenden des Tisches (209) zum Verschieben der Stichprobe (208) in einer zu der ersten Richtung schrägen oder senkrechten Richtung; und
(c) mehrfaches Wiederholen von (a) und (b), um mit jedem Teilstrahl weitere längliche Regionen (724) zu bearbeiten, wobei die resultierende Vielzahl von bearbeiteten länglichen Regionen (724) für jeden Teilstrahl einen teilstrahlbearbeiteten Bereich (740) definiert, wobei die Verschiebungsdistanz der Stichprobe in (b) derart ist, dass die Vielzahl von bearbeiteten länglichen Regionen (724) in jedem teilstrahlbearbeiteten Bereich (740) sich teilweise überlappt oder direkt aneinander angrenzt.

## Revendications

1. Un procédé de traitement d'un échantillon (208) en utilisant un faisceau multiple de particules chargées fourni par une colonne configurée pour diriger une grille de sous-faisceaux de particules chargées sur une surface d'échantillon d'un échantillon, le procédé comprenant : la réalisation des étapes suivantes en séquence :

(a) déplacer l'échantillon (208) dans une direction parallèle à une première direction sur une distance dans la première direction tout en utilisant la colonne pour balayer de façon répétée le faisceau multiple par-dessus la surface d'échantillon dans une direction parallèle à une deuxième direction, traitant de ce fait une région allongée (724) sur la surface d'échantillon avec chaque sous-faisceau, où la première direction et la deuxième direction sont perpendiculaires ou obliques l'une relativement à l'autre ;
(b) décaler l'échantillon (208) dans une direction oblique ou perpendiculaire à la première direction ; et

(c) répéter les étapes (a) et (b) de multiples fois afin de traiter des régions allongées (724) supplémentaires avec chaque sous-faisceau, la pluralité résultante de régions allongées (724) traitées définissant une zone traitée par sous-faisceau (740) pour chaque sous-faisceau, où la distance de décalage de l'échantillon en (b) est telle que la pluralité de régions allongées (724) traitées dans chaque zone traitée par sous-faisceau (740) sont partiellement chevauchantes ou contiguës.

2. Le procédé de la revendication 1, où la distance dans la première direction est substantiellement égale à un pas au niveau de la surface d'échantillon des sous-faisceaux dans le faisceau multiple.

3. Le procédé de la revendication 1 ou de la revendication 2, où une plage de balayage maximale du faisceau multiple par la colonne en (a) est inférieure à un pas minimal au niveau de la surface d'échantillon des sous-faisceaux dans le faisceau multiple.

4. Le procédé de n'importe quelle revendication précédente, où une réalisation de (a) à (c) définit au moins un groupe de zones traitées par sous-faisceau (740) qui sont partiellement chevauchantes ou contiguës les unes par rapport aux autres.

5. Le procédé de n'importe quelle revendication précédente, où le décalage de l'échantillon (208) en (b) est parallèle à la deuxième direction.

6. Le procédé de n'importe quelle revendication précédente, où les balayages du faisceau multiple par-dessus l'échantillon (208) par la colonne en (a) sont tous réalisés dans la même direction.

7. Le procédé de n'importe lesquelles des revendications 1 à 5, où les balayages du faisceau multiple par-dessus l'échantillon (208) par la colonne en (a) sont tous réalisés dans des directions qui alternent.

8. Le procédé de n'importe quelle revendication précédente, où les déplacements de l'échantillon (208) en (a) durant la réalisation répétée de (a) et (b) sont tous dans la même direction.

9. Le procédé de n'importe quelle revendication précédente, comprenant en sus la réalisation des étapes suivantes en séquence après les étapes (a) à (c) où après les étapes (a) à (c) comprend après que la zone traitée par sous-faisceau (740) pour chaque sous-faisceau a été définie par la pluralité de régions allongées (724) traitées de façon souhaitable par le sous-faisceau respectif :

(d) décaler l'échantillon (208) d'une distance égale à au moins deux fois un pas au niveau de la surface d'échantillon (208) des sous-faisceaux dans le faisceau multiple ; et

(e) répéter (a) à (d).

10. Le procédé de la revendication 9, où l'échantillon (208) est déplacé en utilisant des platines à longue course et à faible course (209A, 209B) actionnables indépendamment, une plage de mouvement maximale de la platine à longue course (209A) étant plus longue qu'une plage de mouvement maximale de la platine à faible course (209B).

11. Le procédé de la revendication 10, où l'échantillon (208) est déplacé dans les étapes (a) à (c) en utilisant la platine à faible course (209B), préférablement exclusivement.

12. Le procédé de la revendication 10 ou de la revendication 11, où l'échantillon (208) est déplacé dans l'étape (d) en utilisant la platine à longue course (209A), préférablement exclusivement.

13. Le procédé de n'importe lesquelles des revendications 9 à 12, où le décalage de l'échantillon (208) en (d) est réalisé avec l'échantillon (208) positionné plus loin de la colonne que durant le déplacement de l'échantillon (208) en (a) à (c).

14. Le procédé de n'importe lesquelles des revendications 9 à 13, où :

là où une empreinte de la colonne est définie comme le plus petit cadre de délimitation sur la surface d'échantillon qui entoure la totalité des zones traitées par sous-faisceaux (740) issues d'une réalisation de (a) à (c),
la distance de décalage de l'échantillon (208) en (d) est substantiellement égale ou supérieure à une dimension de l'empreinte parallèle à la direction du déplacement.

15. Un système de particules chargées à faisceau multiple, comprenant :

une platine (209) pour supporter un échantillon (208) présentant une surface d'échantillon ; et
une colonne configurée pour diriger une grille de sous-faisceaux de particules chargées sur la surface d'échantillon, où le système est configuré pour contrôler la platine (209) et la colonne afin de réaliser ce qui suit en séquence :

(a) utiliser la platine (209) pour déplacer l'échantillon (208) dans une direction parallèle à une première direction sur une distance dans la première direction tout en utilisant la colonne pour balayer de façon répétée le faisceau multiple par-dessus la surface d'échantillon dans une direction parallèle à une deuxième direction, traitant de ce fait une région allongée (724) sur la surface d'échantillon avec chaque sous-faisceau, où la première direction et la deuxième direction sont perpendiculaires ou obliques l'une relativement à l'autre ;

(b) utiliser la platine (209) pour décaler l'échantillon (208) dans une direction oblique ou perpendiculaire à la première direction ; et

(c) répéter (a) et (b) de multiples fois afin de traiter des régions allongées (724) supplémentaires avec chaque sous-faisceau, la pluralité résultante de régions allongées (724) traitées définissant une zone traitée par sous-faisceau (740) pour chaque sous-faisceau, où la distance de décalage de l'échantillon en (b) est telle que la pluralité de régions allongées (724) traitées dans chaque zone traitée par sous-faisceau (740) sont partiellement chevauchantes ou contiguës.

# Fig. 1

# Fig. 2

# Fig. 3

# Fig. 4

# Fig. 5

# Fig. 6

## Fig. 7

401 {

402

208

30kV

2.55kV

2.5kV

405  406

## Fig. 8

402

404

405

406

## Fig. 9

406

## Fig. 10

408

409

404

407

405

406

# Fig. 11

# Fig. 12

# Fig. 13

# Fig. 14

# Fig. 15

# Fig. 16

# Fig. 17

# Fig. 18

# Fig. 19

# Fig. 20

Fig. 21

241A    241B    241C

Fig. 22

241D    241E    241F

Fig. 23

241D    241E    241F

241A    241B    241C

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 20213733
- EP 21171877
- US 2018254167 A1
- US 2020203121 A1
- WO 2019238553 A1
- EP 2425444 A
- EP 20158804 A
- EP 20206987 A
- EP 1602121 A1
- EP 20156253
- EP 2702595 A1
- EP 2715768 A2
- EP 20184160
- EP 2638560 A